(19) Europäisches Patentamt
European Patent Office
Office européen des brevets

(11) **EP 3 796 023 A1**

(12) **EUROPÄISCHE PATENTANMELDUNG**

(43) Veröffentlichungstag:
**24.03.2021** Patentblatt **2021/12**

(51) Int Cl.:
***G01R 33/48*** *(2006.01)* ***G01R 33/561*** *(2006.01)*

(21) Anmeldenummer: **19198062.2**

(22) Anmeldetag: **18.09.2019**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Healthcare GmbH**
**91052 Erlangen (DE)**

(72) Erfinder: **Zeller, Mario**
**91054 Erlangen (DE)**

(54) **VERBESSERTES MAGNETRESONANZ-DIXON-VERFAHREN**

(57) Durch Erfassen mindestens zweier Messdatensätze (MD1.1, MD1.2) jeweils aus Messdaten, welche zu Zeitpunkten, an denen Spins einer ersten in dem Untersuchungsobjekt (U) vorhandenen Spinspezies zu Spins einer zweiten in dem Untersuchungsobjekt (U) vorhandenen Spinspezies unterschiedliche Phasenlagen (PL1, PL2) aufweisen, aufgenommen werden, und welche jeweils unter Schalten von Auslesegradienten unterschiedlicher Polarität (GRa, GRb) aufgenommen werden, ist es möglich besonders schnell die gewünschten Messdatensätze (MD1.1, MD1.2) aufzunehmen.

# FIG 1

EP 3 796 023 A1

**Beschreibung**

Die Erfindung betrifft ein verbessertes Magnetresonanz-Dixon-Verfahren.

Die Magnetresonanz-Technik (im Folgenden steht die Abkürzung MR für Magnetresonanz) ist eine bekannte Technik, mit der Bilder vom Inneren eines Untersuchungsobjektes erzeugt werden können. Vereinfacht ausgedrückt wird hierzu das Untersuchungsobjekt in einem Magnetresonanzgerät in einem vergleichsweise starken statischen, homogenen Grundmagnetfeld, auch $B_0$-Feld genannt, mit Feldstärken von 0,2 Tesla bis 7 Tesla und mehr positioniert, so dass sich dessen Kernspins entlang des Grundmagnetfeldes orientieren. Zum Auslösen von Kernspinresonanzen werden hochfrequente Anregungspulse (RF-Pulse) in das Untersuchungsobjekt eingestrahlt, die ausgelösten Kernspinresonanzen als sogenannte k-Raumdaten gemessen und auf deren Basis MR-Bilder rekonstruiert oder Spektroskopiedaten ermittelt. Zur Ortskodierung der Messdaten werden dem Grundmagnetfeld schnell geschaltete magnetische Gradientenfelder überlagert. Die aufgezeichneten Messdaten werden digitalisiert und als komplexe Zahlenwerte in einer k-Raum-Matrix abgelegt. Aus der mit Werten belegten k-Raum-Matrix ist z.B. mittels einer mehrdimensionalen Fourier-Transformation ein zugehöriges MR-Bild rekonstruierbar.

Es sind verschiedene MR-Techniken bekannt, um Signale verschiedener Spinspezies, beispielsweise von Spins in einer Wasserumgebung und Spins in einer Fettumgebung oder auch weiterer Umgebungen, wie insbesondere eine Silikonumgebung, in aufgenommenen MR-Daten zu separieren bzw. um die Signale bestimmter Spinspezies zu unterdrücken. Zu diesen Techniken gehören die sogenannten Multi-Kontrast-Messungen. Im Folgenden werden der Einfachheit halber Spins einer bestimmten Umgebung kurz als Spins der Spinspezies Fett, Wasser, Silikon oder ggf. einer anderen Umgebung entsprechender Spinspezies bezeichnet, ohne den Begriff "Umgebung" unbedingt zu verwenden.

Verschiedene Spinspezies präzedieren unterschiedlich, wodurch ein jeweils unterschiedliches Magnetfeld am Kern entsteht, was zu unterschiedlichen Resonanzfrequenzen führt. Man spricht hierbei auch von einer chemischen Verschiebung (engl. "chemical shift") zwischen den verschiedenen Spinspezies. Dies führt bei der Signalaufnahme zu unterschiedlichen Phasenwinkeln der verschiedenen den jeweiligen Spinspezies entsprechenden Komponenten. Die prominentesten Vertreter von zwei verschiedenen Spinspezies sind Fett und Wasser, wobei jedoch auch andere Anwendungen möglich sind. Die Resonanzfrequenzen von Fett und Wasser unterscheiden sich um ca. 3,3 ppm (Parts per Million). Eine Methode zur Trennung der Signale von zwei unterschiedlichen Gewebearten, wie z.B. Fett und Wasser ist, die Ausnutzung der Phaseninformation aufgenommener MR-Signale.

Eine solche Technik ist die Dixon-Technik, bei der mindestens zwei MR-Datensätze zu jeweils verschiedenen Echozeiten nach einer Anregung und damit mit verschiedenen Kontrasten aufgenommen werden. Hierbei werden die Echozeiten derart gewählt, dass die relative Phasenlage verschiedener Spinspezies der in einem MR-Datensatz enthaltenen Signale in den verschiedenen aufgenommenen MR-Datensätzen unterschiedlich ist. D.h. in zumindest einem der aufgenommenen MR-Datensätze ist die Phasenlage einer der in dem MR-Datensatz enthaltenen Spinspezies relativ zu einer anderen in dem MR-Datensatz enthaltenen Spinspezies anders als in zumindest einem anderen aufgenommenen MR-Datensatz. Mit Kenntnis der jeweiligen Phasenlagen können aus aus den aufgenommenen MR-Datensätzen rekonstruierten MR-Bilddatensätzen Kombinationsbilder extrahiert werden, die z.B. nur Signale von einer Spinspezies darstellen. Die Kombinationsbilder können daher auch als aus den zu den verschiedenen Echozeiten erfassten MR-Datensätzen abgeleitete parametrische Karten bezeichnet werden.

Grundsätzlich kann eine Dixon-Technik mit verschiedenen Sequenztypen realisiert werden, beispielsweise mit (Turbo)-Spinecho-Sequenzen, SSFP-Sequenzen (SSFP: "steady-state free precession") oder auch Gradientenechosequenzen, und ist deshalb vielseitig einsetzbar.

Als verschiedene Phasenlagen, die die Spinspezies relativ zueinander in z.B. zwei aufgenommenen MR-Datensätzen aufweisen, werden häufig einerseits eine selbe Phasenlage der Spinspezies, auch "in-phase" genannt, und andererseits eine entgegengesetzte Phasenlage, auch "opposed-phase" oder "out-of-phase" genannt, gewählt. Es sind jedoch auch andere Phasenlagen denkbar.

Der Erfindung liegt die Aufgabe zugrunde, eine verbesserte Aufnahme von Kombinationsbildern unterschiedlicher Spinspezies derart zu ermöglichen, dass eine Trennung der Kombinationsbilder in Bilder der einzelnen betrachteten Spinspezies möglichst artefaktfrei.

Die Aufgabe wird gelöst durch ein Verfahren zur Aufnahme von mindestens zwei Messdatensätzen eines Untersuchungsobjektes mittels Magnetresonanz gemäß Anspruch 1, eine Magnetresonanzanlage gemäß Anspruch 13, ein Computerprogramm gemäß Anspruch 14 sowie einen elektronisch lesbarer Datenträger gemäß Anspruch 15.

Ein erfindungsgemäßes Verfahren zur Aufnahme von mindestens zwei Messdatensätzen eines Untersuchungsobjektes mittels Magnetresonanz umfasst die Schritte:

- Einstrahlen mindestens eines RF-Anregungspulses zur Anregung von Spins in dem Untersuchungsobjekt,
- Erfassen erster Messdaten eines nach einem eingestrahlten RF-Anregungspuls erzeugten Echosignals zu einem ersten Zeitpunkt, in dem Spins einer ersten in dem Untersuchungsobjekt vorhandenen Spinspezies zu Spins einer zweiten in dem Untersuchungsobjekt vorhandenen Spinspezies eine erste Phasenlage aufweisen, unter Schalten eines Auslesegradienten einer ersten Polarität,

- Erfassen zweiter Messdaten eines durch den RF-Anregungspuls erzeugten Echosignals zu einem zweiten Zeitpunkt, in dem Spins der ersten in dem Untersuchungsobjekt vorhandenen Spinspezies zu Spins der zweiten in dem Untersuchungsobjekt vorhandenen Spinspezies eine zweite, von der ersten Phasenlage verschiedenen, Phasenlage aufweisen, unter Schalten eines Auslesegradienten einer zweiten Polarität, wobei die erste und die zweite Polarität verschieden sind,
- Erzeugen eines ersten Kombinationsbildes (OP1) auf Basis der erfassten ersten Messdaten,
- Erzeugen eines zweiten Kombinationsbildes (IP1) auf Basis der erfassten zweiten Messdaten,
- Erstellen eines mindestens eines Bildes, welches nur Signale einer Spinspezies aus der Gruppe der ersten und der zweiten Spinspezies darstellt, auf Basis des ersten und des zweiten Kombinationsbildes.

Durch das erfindungsgemäße Erfassen mindestens zweier Messdatensätze jeweils aus Messdaten, welche zu Zeitpunkten, an denen Spins einer ersten in dem Untersuchungsobjekt vorhandenen Spinspezies zu Spins einer zweiten in dem Untersuchungsobjekt vorhandenen Spinspezies unterschiedliche Phasenlagen aufweisen, aufgenommen werden, und welche jeweils unter Schalten von Auslesegradienten unterschiedlicher Polarität aufgenommen werden, ist es möglich besonders schnell die gewünschten Messdatensätze aufzunehmen.

Eine erfindungsgemäße Magnetresonanzanlage umfasst eine Magneteinheit, eine Gradienteneinheit, eine Hochfrequenz-einheit und eine zur Durchführung eines erfindungsgemäßen Verfahrens ausgebildete Steuereinrichtung mit einer Messdatenverarbeitungseinheit.

Ein erfindungsgemäßes Computerprogramm implementiert ein erfindungsgemäßes Verfahren auf einer Steuereinrichtung, wenn es auf der Steuereinrichtung ausgeführt wird.

Das Computerprogramm kann hierbei auch in Form eines Computerprogrammprodukts vorliegen, welches direkt in einen Speicher einer Steuereinrichtung ladbar ist, mit Programm-code-Mitteln, um ein erfindungsgemäßes Verfahren auszuführen, wenn das Computerprogrammprodukt in der Recheneinheit des Rechensystems ausgeführt wird.

Ein erfindungsgemäßer elektronisch lesbarer Datenträger umfasst darauf gespeicherte elektronisch lesbare Steuerinformationen, welche zumindest ein erfindungsgemäßes Computerprogramm umfassen und derart ausgestaltet sind, dass sie bei Verwendung des Datenträgers in einer Steuereinrichtung einer Magnetresonanzanlage ein erfindungsgemäßes Verfahren durchführen.

Die in Bezug auf das Verfahren angegebenen Vorteile und Ausführungen gelten analog auch für die Magnetresonanzanlage, das Computerprogramm und den elektronisch lesbaren Datenträger.

Weitere Vorteile und Einzelheiten der vorliegenden Erfindung ergeben sich aus den im Folgenden beschriebenen Ausführungsbeispielen sowie anhand der Zeichnungen. Die aufgeführten Beispiele stellen keine Beschränkung der Erfindung dar. Es zeigen:

Figs. 1-5 beispielhafte schematische Sequenzdiagramme wie sie für ein erfindungsgemäßes Verfahren eingesetzt werden können,

Figs. 6-8 beispielhafte Darstellungen von k-Raumtrajektorien zu unterschiedlichen Zeitpunkten aufgenommener Messdaten, wie sie für ein erfindungsgemäßes Verfahren erfasst werden können,

Fig. 9 ein schematisches Ablaufdiagramm einer möglichen Erstellung von Bildern, welche nur Signale einer betrachteten Spinspezies enthalten, aus erfindungsgemäß aufgenommenen Messdaten,

Fig. 10 eine schematisch dargestellte erfindungsgemäße Magnetresonanzanlage.

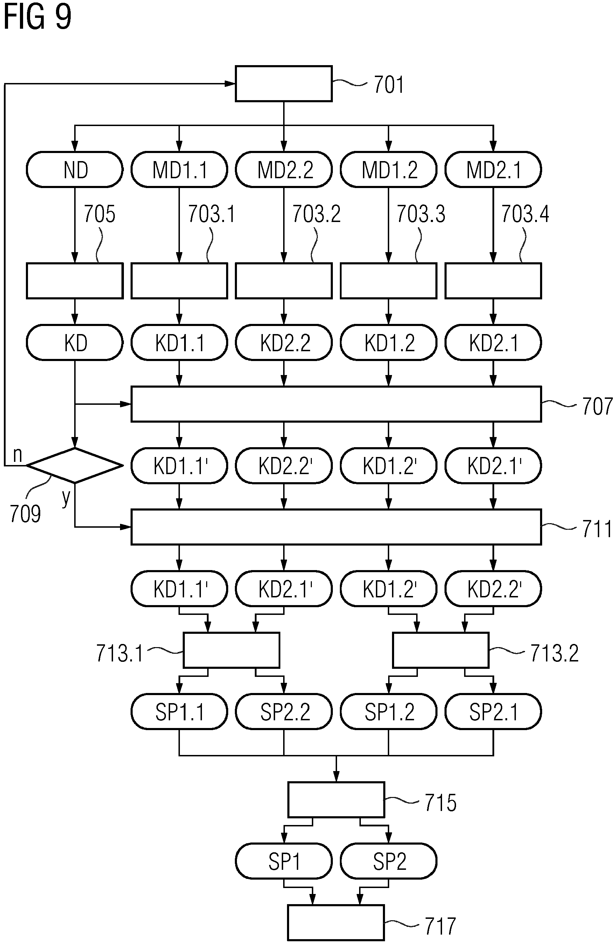

Figur 9 ist ein schematisches Ablaufdiagramm eines erfindungsgemäßen Verfahrens zur Aufnahme von mindestens zwei Messdatensätzen eines Untersuchungsobjektes mittels Magnetresonanz.

Nach Einstrahlen mindestens eines RF-Anregungspulses RF1 werden hierbei mindestens zwei Messdatensätze, beispielsweise je ein Messdatensatz, welcher erste Messdaten MD1.1 und/oder MD1.2 umfasst, und ein zweiter Messdatensatz, welcher zweite Messdaten MD2.1 und/oder MD2.2 umfasst, durch Erfassen der jeweiligen Messdaten aufgenommen (Block 701).

Genauer werden erste Messdaten MD1.1 und/oder MD1.2 zu einem ersten Zeitpunkt erfasst, zu dem Spins einer ersten in dem Untersuchungsobjekt vorhandenen Spinspezies zu Spins einer zweiten in dem Untersuchungsobjekt vorhandenen Spinspezies eine erste Phasenlage aufweisen. Eine Phasenlage von Spins der verschiedenen Spinspezies beschreibt hierbei die Lage der Phase der Spins der ersten Spinspezies relativ zu der Lage der Phase der Spins der zweiten Spinspezies. Während des Erfassens der ersten Messdaten MD1.1 wird ein Auslesegradient geschaltet, der eine erste Polarität aufweist. Derart erfasste erste Messdaten können beispielsweise in einen ersten Messdatensatz eingehen.

Weiterhin werden zweite Messdaten MD2.1 und/oder MD2.2 zu einem zweiten Zeitpunkt erfasst, zu dem Spins der ersten in dem Untersuchungsobjekt vorhandenen Spinspezies zu Spins der zweiten in dem Untersuchungsobjekt vorhandenen Spinspezies eine zweite, von der ersten verschiedene, Phasenlage aufweisen. Während des Erfassens der zweiten Messdaten MD2.2 wird ein Auslesegradient geschaltet, der eine zweite Polarität aufweist, die verschieden von der ersten Polarität ist. Derart erfasste zweite Messdaten können beispielsweise in einen zweiten Messdatensatz eingehen.

Es ist beispielsweise möglich, Messdaten eines Messdatensatzes der erfindungsgemäß aufgenommenen zwei Messdatensätze zu einem Zeitpunkt zu erfassen, zu dem Spins der ersten in dem Untersuchungsobjekt vorhandenen Spinspezies und Spins der zweiten in dem Untersuchungsobjekt vorhandenen Spinspezies eine selbe Phase aufweisen (Phasenlage: "in-Phase").

Es können auch zusätzlich oder alternativ Messdaten eines Messdatensatzes der erfindungsgemäß aufgenommenen zwei Messdatensätze zu einem Zeitpunkt erfasst werden, zu dem Spins der ersten in dem Untersuchungsobjekt vorhandenen Spinspezies eine Phase aufweisen, die der Phase, die Spins der zweiten in dem Untersuchungsobjekt vorhandenen Spinspezies aufweisen, entgegengesetzt ist (Phasenlage: "opposed-Phase").

Weitere Phasenlagen sind denkbar, und können, unter anderem je nach gewünschtem zeitlichen Abstand der jeweiligen Echosignale, gewählt werden, wobei eine bei Dixon-Techniken übliche Anforderung an die Unterscheidbarkeit der gewählten Phasenlagen gestellt werden sollte.

Für das Erfassen der ersten und zweiten Messdaten sind verschiedene Vorgehensweisen denkbar.

Eine spezielle Dixon-Technik, auch "fast Dixon" genannt, erfasst die Messdaten für die z.B. zwei verschiedenen MR-Datensätze nach einem gemeinsamen RF-Anregungs- bzw. RF-Refokussierungspuls (beispielsweise nach jedem RF-Refokussierungspuls einer Turbo-Spin-Echo(TSE)-Sequenz), wobei ein bipolarer Auslesegradient während der Aufnahme der Messdaten geschaltet wird, d.h. der Auslesegradient hat eine erste Polarität während Messdaten für den ersten MR-Datensatz aufgenommen werden, und eine andere Polarität während Messdaten für den zweiten MR-Datensatz aufgenommen werden. Eine derartige bipolare Aufnahme erlaubt es, die Messdaten für die, z.B. zwei, verschiedenen MR-Datensätze innerhalb eines gemeinsamen Echozuges zu erfassen. Auf diese Weise ist es nicht mehr nötig, die Messdaten für die verschiedenen MR-Datensätze in separaten Messungen aufzunehmen, wie es z.B. in Standard TSE Dixon-Verfahren der Fall ist, die für jeden MR-Datensatz eine eigene Messung der benötigten Messdaten einsetzten, wodurch die insgesamte Messzeit für fast Dixon deutlich gegenüber solchen Standard Dixon Techniken reduziert wird.

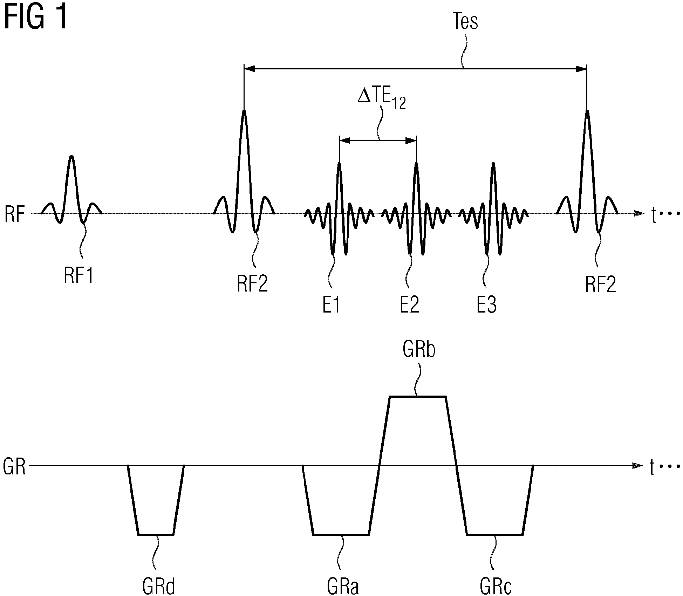

Ein schematisches Beispiel eines Ausschnitts eines möglichen Sequenzdiagramms für ein solches Vorgehen, ist in Figur 1 dargestellt.

In der oberen Zeile RF sind hierbei beispielhafte Hochfrequenzsignale, die eingestrahlt RF1, RF2 oder empfangen E1, E2, E3 werden können, und in der unteren Zeile beispielhafte zu schaltende Gradienten GRa, GRb, GRc, GRd in Ausleserichtung GR in ihrem Ablauf über die Zeit t dargestellt.

Nach einem RF-Anregungspuls RF1 kann eine Reihe von mehreren Refokussierungspulsen RF2 eingestrahlt werden, um, unter Schaltung von Gradienten in Ausleserichtung zumindest zwei Echosignale E1 und E2 und ggf. E3 oder mehr Echosignale zu erzeugen und auszulesen. Ein zeitlicher Abstand Tes zwischen zwei aufeinanderfolgenden RF-Refokussierungspulsen RF2 entspricht hierbei einem zeitlichen Abstand gleichartiger, jeweils nach den aufeinanderfolgenden RF-Refokussierungspulsen RF2 erzeugten Echosignalen E1, E2 oder E3. Der Übersichtlichkeit halber sind mögliche Gradienten, die in Schichtrichtung und/oder Phasenkodierrichtung für eine räumliche Kodierung der Messdaten geschaltet werden können, nicht dargestellt.

Das dargestellte Sequenzdiagramm entspricht grundsätzlich einem GRASE("Gradient and Spin echo")-Sequenzdiagramm, bei welchem nach einem RF-Anregungspuls RF1 mindestens ein RF-Refokussierungspuls RF2 eingestrahlt wird, und nach einem RF-Refokussierungspuls RF2 ebenfalls z.B. drei Echosignale E1, E2, E3 erzeugt und ausgelesen werden können. Das Echosignal E1 wird in der Darstellung unter Schaltung eines Auslesegradienten GRa mit einer ersten, hier negativen, Polarität ausgelesen und das auf das Echosignal E1 folgende Echosignal E2 wird unter Schaltung eines Auslesegradienten GRb mit einer zweiten, von der ersten verschiedenen, hier positiven, Polarität ausgelesen. Weiterhin kann ein drittes Echosignal E3 unter Schaltung eines weiteren Auslesegradienten GRc ausgelesen werden, der typischerweise wieder dieselbe Polarität hat, wie der während des Auslesens des ersten Echosignals E1 geschaltete Auslesegradient GRa.

Es wird hier also z.B. nach einem eingestrahlten RF-Anregungspuls RF1 mindestens ein RF-Refokussierungspuls RF2 eingestrahlt, und ein erster Zeitpunkt, zu dem ein erstes Echosignal E1 erzeugt und ausgelesen wird und ein zweiter Zeitpunkt, zu dem ein zweites Echosignal E2 erzeugt und ausgelesen wird, folgen jeweils zeitlich auf einen Zeitpunkt, zu dem ein RF-Refokussierungspuls RF2 eingestrahlt wurde.

Es ist möglich, ein drittes Echosignal E3 zu einem Zeitpunkt auszulesen, zu dem die betrachteten Spinspezies wieder dieselbe Phasenlage aufweisen wie zu dem Zeitpunkt des ersten Echosignals E1, wobei dazu der zeitliche

Abstand $\Delta TE_{23}$ (nicht dargestellt) zwischen dem zweiten Echosignal E2 und dem dritten Echosignal E3 entsprechend gewählt werden muss. Ein derartiges Vorgehen wird beispielsweise in dem Artikel von Ma et al., "Fast Spin-Echo Triple-Echo Dixon (fTED) Technique for Efficient T2-Weighted Water and Fat Imaging", MRM 58, S. 103-109, 2007, beschrieben.

Der in Figur 1 gezeigte Auslesegradient GRc kann aber auch zusätzlich oder alternativ zur Dephasierung der Magnetisierung vor dem Einstrahlen eines nachfolgenden Refokussierungspulses RF2 eingesetzt werden. Nach Auslesen der Echosignale E1, E2 und ggf. E3 kann ein weiterer RF-Refokussierungspuls RF2 geschaltet werden, nach welchem wiederum durch Schalten von Auslesegradienten weitere Echosignale (nicht mehr dargestellt) erzeugt und ausgelesen werden können.

Im Vergleich zu einer herkömmlichen GRASE-Sequenz werden für ein Dixon-Verfahren zusätzlich die jeweiligen Phasenlagen der Spins der verschiedenen in dem Untersuchungsobjekt vorhandenen Spinspezies bei der Zeiteinteilung wie oben beschrieben berücksichtigt.

Es können z.B. erste erste Messdaten MD1.1 durch Auslesen von in Figur 1 beschriebenen Echosignalen E1 unter Schalten eines Auslesegradienten GRa einer ersten Polarität und erste zweite Messdaten MD2.2 durch Auslesen von in Figur 1 beschriebenen Echosignalen E2 unter Schalten eines Auslesegradienten GRb einer zweiten Polarität erfasst werden.

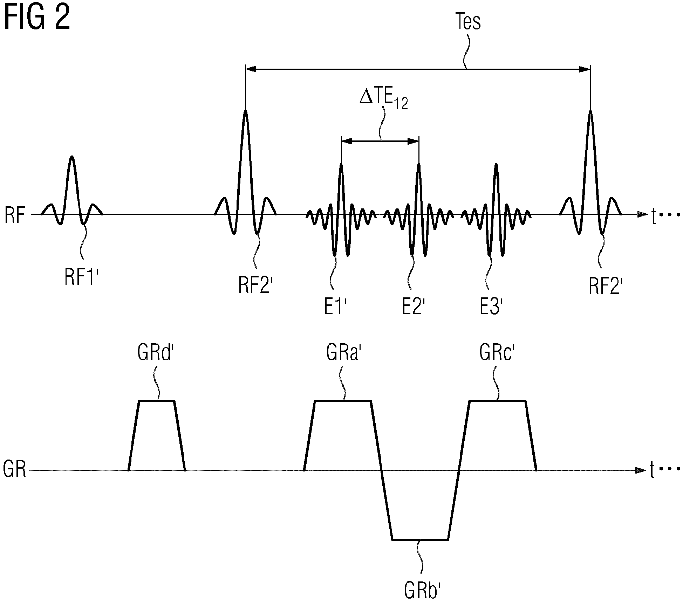

Ein weiteres schematisches Beispiel eines Ausschnitts eines möglichen Sequenzdiagramms für ein solches Vorgehen, ist in Figur 2 dargestellt. Das in Figur 2 gezeigte Beispiel unterschiedet sich von dem in Figur 1 dargestellten Beispiel in erster Linie durch eine Umkehrung der Polaritäten der in Ausleserichtung GR in Figur 2 geschalteten Gradienten GRa', GRb', GRc' und GRd' jeweils im Vergleich zu den in Figur 1 geschalteten Gradienten GRa, GRb, GRc und GRd. Nach Einstrahlen eines RF-Anregungspulses RF1' und z.B. mindestens eines RF-Refokussierungspulses RF2' können somit Echosignale E1', E2' und E3' erzeugt und ausgelesen werden, wobei in Figur 2 die Polarität der Gradienten GRa', GRb', GRc' und GRd' in Ausleserichtung GR, und damit die Ausleserichtung im k-Raum, in welcher die gezeigten Echosignale E1', E2' und E3' erfasst werden, jeweils entgegengesetzt zu der Polarität bzw. Ausleserichtung im k-Raum der entsprechenden Gradienten GRa, GRb, GRc und GRd bzw. der entsprechenden Echosignale E1, E2, E3 aus Figur 1 ist. Im Übrigen gelten für die Echosignale E1', E2' und E3' sowie für die Gradienten GRa', GRb', GRc' und GRd' analog die oben mit Bezug auf die Echosignale E1, E2 und E3 sowie die Gradienten GRa, GRb, GRc, GRd mit Bezug zu Figur 1 gemachten Ausführungen.

Es können z.B. zweite erste Messdaten MD1.2 durch Auslesen von in Figur 2 beschriebenen Echosignalen E1' unter Schalten eines Auslesegradienten GRa' der (im Vergleich zu Figur 1) zweiten Polarität und zweite zweite Messdaten MD2.1 durch Auslesen von in Figur 2 beschriebenen Echosignalen E2' unter Schalten eines Auslesegradienten GRb' der (im Vergleich zu Figur 1) ersten Polarität erfasst werden. Somit würden unter Schalten eines Auslesegradienten GRa' einer zweiten Polarität, die sich von einer ersten Polarität unterscheidet, welche ein Auslesegradient GRa aufweist, unter welchen erste erste Messdaten MD1.1 erfasst wurden, zweite erste Messdaten MD1.2 eines durch einen RF-Anregungspuls RF1' erzeugten Echosignals E1' zu einem Zeitpunkt erfasst werden, in dem Spins der ersten in dem Untersuchungsobjekt vorhandenen Spinspezies zu Spins der zweiten in dem Untersuchungsobjekt vorhandenen Spinspezies die erste Phasenlage aufweisen. Weiterhin würden somit unter Schalten eines Auslesegradienten GRb' der ersten Polarität zweite zweite Messdaten MD2.1 eines durch den RF-Anregungspuls RF1' erzeugten Echosignals E2' zu einem Zeitpunkt erfasst werden, in dem Spins der ersten in dem Untersuchungsobjekt vorhandenen Spinspezies zu Spins der zweiten in dem Untersuchungsobjekt vorhandenen Spinspezies die zweite Phasenlage aufweisen.

Unter Verwendung von Sequenzdiagrammen gemäß den Figuren 1 und 2 können erste erste und erste zweite Messdaten MD1.1 und MD2.2 nach einem gemeinsamen RF-Anregungspuls RF1 erfasst werden, und zweite erste und zweite zweite Messdaten MD1.2 und MD2.1 nach einem anderen gemeinsamen RF-Anregungspuls RF1' erfasst werden.

Insbesondere, um eine Bewegung des Untersuchungsobjekts zwischen den Aufnahmen der ersten ersten und ersten zweiten Messdaten MD1.1 und MD2.2 einerseits und zweiten ersten und zweiten zweiten Messdaten MD1.2 und MD2.1 andererseits möglichst gering zu halten, kann ein Erfassen erster erster und erster zweiter Messdaten MD1.1 und MD2.2 einerseits und ein Erfassen ihrer bezüglich ihrer k-Raumposition entsprechenden zweiter ersten und zweiter zweiten Messdaten MD1.2 und MD2.1 andererseits mit einem möglichst kleinen zeitlichen Abstand erfolgen, d.h. die Aufnahmen der ersten ersten und ersten zweiten Messdaten MD1.1 und MD2.2 einerseits und zweiten ersten und zweiten zweiten Messdaten MD1.2 und MD2.1 andererseits kann mit möglichst geringem zeitlichen Abstand, z.B. nur eine Wiederholzeit TR beabstandet, nacheinander ausgeführt werden.

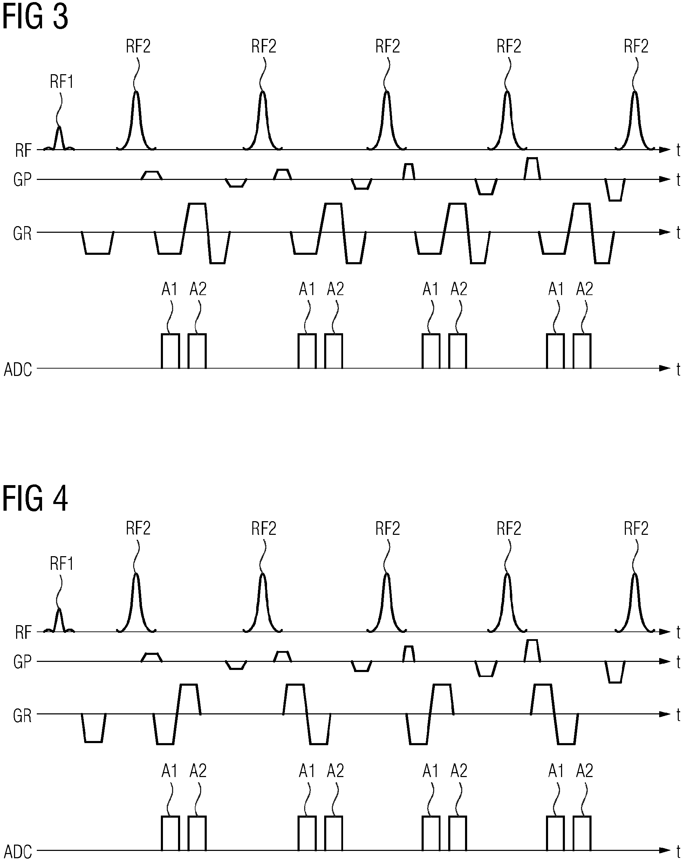

Figur 3 zeigt ein weiteres schematisches Beispiel eines Ausschnitts eines möglichen Sequenzdiagramms für ein hierin beschriebenes Verfahren, das dem in Figur 1 gezeigten Beispiel verwandt ist, jedoch im Detail etwas anders ausgestaltet ist, um weitere Varianten zu verdeutlichen. Im Unterschied zu den Figuren 1 und 2 sind in Figur 3 nicht die erzeugten Echosignale dargestellt, sondern in der Zeile ADC Auslesefenster A1 und A2, die die Zeitfenster wiedergeben, in welchen ein jeweiliges Erfassen erster Messdaten, z.B. in Auslesefenstern A1, und zweiter Messdaten, z.B. in Auslesefenstern A2, stattfindet. Für den einzuhaltenden zeitlichen Abstand jeweils nach einem gemeinsamen RF-Refokussierungspuls aufeinanderfolgender Auslesefenster A1 und A2 gilt hierbei dasselbe wie für den zeitlichen Abstand $\Delta TE_{12}$ der beiden aufgenommenen Echosignale E1 und E2 bzw. E1' und E2' in den Figuren 1 und 2. Darüber hinaus sind in Figur 3 beispielhaft fünf (deutlich mehr sind denkbar) RF-Refokussierungspulse RF2, welche auf einen ihnen gemeinsamen RF-Anregungspuls RF1 folgen, und die Gradientenschaltung in Phasenkodierrichtung GP dargestellt, um zu verdeutlichen, wie die Gradienten in Phasenkodierrichtung GP für aufeinanderfolgende RF-Refokussierungspulse RF2 jeweils geändert werden können, um nach jedem RF-Refokussierungspuls RF2 anders kodierte Messdaten, z.B. je eine andere k-Raumzeile, in den jeweiligen, verschiedenen RF-Refokussierungspulsen RF2 zugeordneten Auslesefenstern A1 und A2 erfassen zu können. Beispielsweise können nach einem ersten RF-Refokussierungspuls RF2 eine erste k-Raumzeile in den dem ersten RF-Refokussierungspuls zugeordneten Auslesefenstern A1 und A2 ausgelesen werden, und nach einem zweiten, von dem ersten RF-Refokussierungspuls RF2 verschiedenen, RF-Refokussierungspuls RF2 eine andere, von der ersten k-Raumzeile verschiedene, k-Raumzeile in den dem zweiten RF-Refokussierungspuls RF2 zugeordneten Auslesefenstern A1 und A2 ausgelesen werden.

Hierbei können, die in dem hier gezeigten Beispiel dargestellten Gradienten in Phasenkodierrichtung GP, welche unmittelbar vor einem RF-Refokussierungspuls RF2 geschaltet werden, und/oder die in dem hier gezeigten Beispiel dargestellten Gradienten in Ausleserichtung GR, die zeitlich unmittelbar auf ein Auslesefenster A2 folgen, der Dephasierung der jeweils noch angeregten Spins dienen. Je mehr RF-Refokussierungspulse RF2 nach einem gemeinsamen RF-Anregungspuls RF1 eingestrahlt werden, desto schneller können die gewünschten Messdaten erfasst werden.

Es können z.B. erste erste Messdaten MD1.1 in den in Figur 3 beschriebenen Auslesefenstern A1 und erste zweite Messdaten MD2.2 in den in Figur 3 beschriebenen Auslesefenstern A2 erfasst werden. Werden die in Figur 3 gezeigten Gradienten in Ausleserichtung GR bezüglich ihrer Polarität umgekehrt (wie die Auslesegradienten GRa', GRb', GRc', GRd' aus Figur 2 gegenüber den Auslesegradienten GRa, GRb, GRc, GRd aus Figur 1 umgekehrt sind), können mit einer derartigen Schaltung der Pulssequenz (nicht dargestellt) z.B. zweite erste Messdaten MD1.2 in den entsprechenden Auslesefenstern A1 und zweite zweite Messdaten MD2.1 in den entsprechenden Auslesefenstern A2 erfasst werden. Für auf diese Weise erfasste erste erste, erste zweite, zweite erste und zweite zweite Messdaten MD1.1, MD2.1, MD1.2 und MD2.2 gelten im Wesentlichen dieselben Aussagen, wie sie bereits oben mit Bezug auf die Figuren 1 und 2 gemacht wurden.

Figur 4 zeigt ein weiteres schematisches Beispiel eines Ausschnitts eines möglichen Sequenzdiagramms für ein hierin beschriebenes Verfahren, das sich von dem in Figur 3 gezeigten Beispiel hauptsächlich durch die Schaltung der Gradienten in Ausleserichtung GR unterscheidet. Die oben mit Bezug auf Figur 3 gemachten Ausführungen bezüglich eines einzuhaltenden zeitlichen Abstands jeweils nach einem gemeinsamen RF-Refokussierungspuls aufeinanderfolgender Auslesefenster A1 und A2, der einem zeitlichen Abstand $\Delta TE_{12}$ der beiden aufgenommenen Echosignale E1 und E2 bzw. E1' und E2' in den Figuren 1 und 2 entspricht, gelten für das in Figur 4 dargestellte Beispiel analog.

In dem in Figur 4 gezeigten Beispiel werden ebenfalls erste und zweite Messdaten MD1.1 und MD2.2 bzw. MD1.2 und MD2.1 nach je einem gemeinsamen RF-Refokussierungspuls RF2 jeweils in Auslesefenstern A1 und A2 aufgenommen, jedoch werden nach einem eingestrahlten RF-Anregungspuls RF1 eine Folge von RF-Refokussierungspulsen RF2 eingestrahlt, und nach aufeinanderfolgenden RF-Refokussierungspulsen RF2 der Folge nunmehr abwechselnd erste erste und erste zweite Messdaten MD1.1 und MD2.2 einerseits (z.B. nach einem ersten RF-Refokussierungspuls RF2) und zweite erste und zweite zweite Messdaten MD1.2 und MD2.1 andererseits (nach einem auf den ersten RF-Refokussierungspuls RF2 folgenden RF-Refokussierungspuls RF2) erfasst. Dies kann erfolgen, indem die während der Auslesefenster A1 einerseits und A2 andererseits geschalteten Gradienten in Ausleserichtung GR nach aufeinanderfolgenden RF-Refokussierungspulsen RF2 wie dargestellt umgekehrt werden. Die Polarität der während der Auslesefenster A1 bzw. A2 geschalteten Gradienten in Ausleserichtung GR alterniert somit für aufeinanderfolgenden RF-Refokussierungspulsen RF2 zugeordnete Auslesefenster A1 bzw. A2. Ein Sequenzdiagramm mit nach jedem RF-Refokussierungspuls RF2 umgekehrten Gradienten in Ausleserichtung Gr, wie es z.B. in Figur 4 gezeigt ist, hat, neben der Möglichkeit einer Aufnahme aller für die Bildgebung erforderlichen Messdaten in nur einem Messgang, den weiteren Vorteil, dass eben wegen der alternierenden Schaltung der Gradienten in Ausleserichtung GR auf zusätzliche Dephasier-/Rückdreh-Gradienten verzichtet werden kann. Daher wird kein Zeitfenster für derartige Dephasier-/Rückdreh-Gradienten benötigt und das Pulssequenzdiagramm kann entsprechend eng gestaltet werden und damit schneller die erforderlichen Messdaten erfassen, insbesondere kann (unter Berücksichtigung der gewählten ersten und zweiten Phasenlage) der zeitliche Abstand $\Delta TE_{12}$ bzw. $\Delta TE_{12}$ zwischen zwei erzeugten und auszulesenden Echosignalen verkürzt werden.

Auf eine oben beschriebene Weise können somit z.B. erste erste Messdaten MD1.1, erste zweite Messdaten MD2.2, zweite erste Messdaten MD1.2 und zweite zweite Messdaten MD2.1 nach einem gemeinsamen RF-Anregungspuls RF1 erfasst werden.

Auf Basis erfasster erster Messdaten MD1.1 bzw. MD1.2 kann ein erstes Kombinationsbild KD1.1 bzw. KD1.2 erzeugt, und auf Basis erfasster zweiter Messdaten MD2.1 bzw. MD2.2 kann ein zweites Kombinationsbild KD2.1 bzw. KD2.2 erzeugt werden (Blöcke 703.1, 703.2, 703.3, 703.4), wobei ein Kombinationsbild jeweils Signale aller angeregter, also insbesondere der ersten und der zweiten in dem Untersuchungsobjekt befindlichen, Spinspezies umfasst.

Bei dem Erfassen der ersten Messdaten MD1.1 und/oder MD1.2 und bei dem Erfassen der zweiten Messdaten MD2.2 und/oder MD2.1, ist es möglich, die Messdaten derart aufzunehmen, dass alle erfassten ersten ersten Messdaten MD1.1 einen gemäß Nyquist unterabgetasteten Satz erster erster Messdaten MD1.1 ergeben und/oder alle erfassten ersten zweiten Messdaten MD2.2 einen gemäß Nyquist unterabgetasteten Satz erster zweiter Messdaten MD2.2 ergeben und/oder alle erfassten zweiten ersten Messdaten MD1.2 einen gemäß Nyquist unterabgetasteten Satz zweiter erster Messdaten MD1.2 ergeben und/oder alle erfassten zweiten zweiten Messdaten MD2.1 einen gemäß Nyquist unterabgetasteten Satz zweiter zweiter Messdaten MD2.1 ergeben.

Wurden Messdaten MD1.1, MD2.1, MD1.2 und/oder MD2.2 als gemäß Nyquist unterabgetastet erfasst, kann das jeweilige Erzeugen eines entsprechenden Kombinationsbildes KD1.1, KD2.1, KD1.2 und/oder KD2.2 in den entsprechenden Blöcken 703.1, 703.2, 703.3, 703.4 ein Auffüllen nicht-erfasster, jedoch gemäß Nyquist geforderter Messdaten umfassen. Ein derartiges Auffüllen kann, insbesondere mittels einer parallelen Bildgebungstechnik (ppa, engl. "partial parallel acquisition"), wie z.B. SMASH (engl. "simultaneous acquisition of spatial harmonics"), GRAPPA (engl. "generalized autocalibrating partially parallel acquisition") oder SENSE (engl. "sensitivity encoding"), erfolgen. Hierbei können Messdaten mithilfe von mehreren Empfangsspulen erfasst werden und unterabgetastete Sätze von ersten ersten, ersten zweiten, zweiten ersten oder zweiten zweiten erfassten Messdaten MD1.1, MD2.2, MD1.2, MD2.1 unter Verwendung einer parallelen Bildgebungstechnik zu vollständigen Sätzen an Messdaten ergänzt werden.

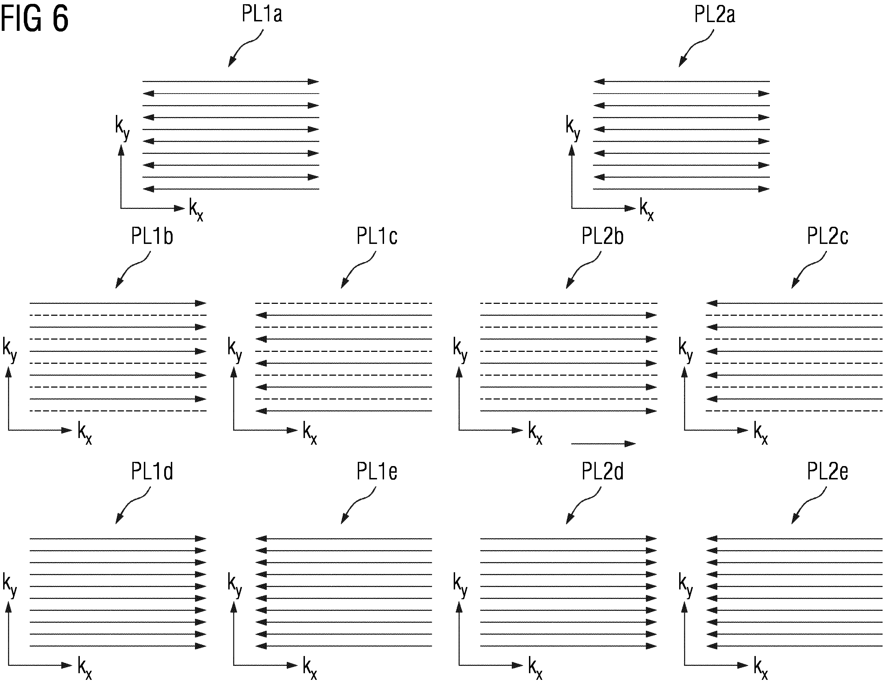

Eine gemäß Nyquist unterabgetastete Aufnahme von Messdaten kann beispielsweise wie in Figur 6, in der jeweils der k-Raum in der von Ausleserichtung kx und Phasenkodierrichtung ky aufgespannten Ebene für verschiedene Beispiele möglicher Vorgehensweisen bei der Aufnahme von Messdaten zu unterschiedlichen Zeitpunkten dargestellt ist, in der mittleren Zeile dargestellt, erfolgen. Eine Kodierung in kz-Richtung, z.B. durch Gradienten in Schichtselektionsrichtung, kann zusätzlich ausgeführt werden, um nur Spins einer bestimmten Schicht oder eines bestimmten begrenzten Volumens anzuregen.

In Figur 6 sind die k-Raumtrajektorien, hier z.B. als k-Raumzeilen, entlang derer Messdaten erfasst werden, oder entlang welcher Messdaten ggf. mittels, z.B. einer ppa-Technik, ergänzt wurden, jeweils als durchgehend gezeichnete Pfeile dargestellt, wobei die Pfeilrichtung die Ausleserichtung wiedergibt. k-Raumtrajektorien von nicht erfassten Messdaten sind als gestrichelt dargestellte Linien wiedergegeben.

In der mittleren Zeile von Figur 6 sind vier k-Räume PL1b, PL1c, PL2b und PL2c dargestellt, die jeweils nur in jeder zweiten gemäß Nyquist zu füllenden k-Raumzeile mit Messdaten befüllt sind. Hierbei sind die k-Raumzeilen der k-Räume PL1b und PL1c mit ersten Messdaten befüllt, welche zu einem Zeitpunkt erfasst wurden, zu dem Spins einer ersten in dem Untersuchungsobjekt vorhandenen Spinspezies zu Spins einer zweiten in dem Untersuchungsobjekt vorhandenen Spinspezies eine erste Phasenlage aufweisen, und die k-Raumzeilen der k-Räume PL2b und PL2c mit zweiten Messdaten befüllt, welche zu einem Zeitpunkt erfasst wurden, zu dem Spins der ersten in dem Untersuchungsobjekt vorhandenen Spinspezies zu Spins der zweiten in dem Untersuchungsobjekt vorhandenen Spinspezies eine zweite Phasenlage aufweisen.

Somit fehlen hier in einem unterabgetasteten Satz erster erster PL1b, erster zweiter PL2c, zweiter erster PL1c oder zweiter zweiter PL2b erfasster Messdaten jeweils Messdaten jeder zweiten k-Raumzeile.

In den in Figur 6 in der mittleren Zeile gezeigten Beispielen sind in den k-Räumen PL1 und PL1c sowie in den k-Räumen PL2b und PL2c jeweils unterschiedliche k-Raumzeilen mit erfassten Messdaten in unterschiedliche Ausleserichtungen gefüllt. Eine derartige Aufnahme von Messdaten kann beispielsweise mithilfe eines Sequenzdiagramms gemäß einer der Figuren 1, 2 oder 3 aufgenommen werden, indem die Gradienten in Phasenkodierrichtung GP jeweils derart geschaltet werden, dass nicht alle gemäß Nyquist erforderlichen Messdaten erfasst werden (wodurch die erfassten Messdaten wie in Figur 6 unten gezeigte k-Räume PL1d, PL1e, PL2d und PL2e füllen würden), sondern z.B. eben nur jede zweite k-Raumzeile. Es ist jedoch auch möglich ein Sequenzdiagramm gemäß Figur 4 zu verwenden, welches z.B. die ersten Messdaten wie in Figur 6 oben links dargestellt in einem k-Raum PL1a zeilenweise in abwechselnder Ausleserichtung ausliest, und die zweiten Messdaten wie in Figur 6 oben rechts dargestellt in einem k-Raum PL2a zeilenweise in abwechselnder Ausleserichtung ausliest. Derartig aufgenommene Messdaten können in besonders kurzer Messzeit, auch in nur einem Messgang (als sogenannte single-shot-Aufnahme) mindestens in einer einem Fast-Dixon-Verfahren entsprechenden Schnelligkeit (oder schneller), erfasst werden und anschließend gemäß ihrer Ausleserichtung (und damit gemäß der jeweiligen Polarität der verwendeten Gradienten in Ausleserichtung während dem Erfassen der Messdaten) in k-Räume PL1b und PL1c bzw. PL2b und PL2c separiert werden, bevor fehlende Messdaten in den jeweiligen k-Räumen, z.B. mittels einer ppa-Technik, ergänzt werden. Schaltet man die Gradienten in Phasenkodierrichtung entsprechend, können auch mit einem Sequenzdiagramm gemäß Figur 4 Messdaten für eine jeweils vollständige Füllung des k-Raums erfasst werden, wozu ggf. auch eine Wiederholung einer Aufnahme nach einem Einstrahlen eines erneuten RF-Anregungspulses RF1 durchgeführt werden kann.

Es ist in jedem Fall auch denkbar, dass die Messdaten derart aufgenommen werden, dass sie dieselben k-Raumzeilen in den k-Räumen PL1b und PL1c sowie PL2b und PL2c in den unterschiedlichen Ausleserichtungen füllen. Dafür wären die Gradienten in Phasenkodierrichtung entsprechend anzupassen.

Nach einer jeweiligen Ergänzung fehlender Messdaten in unterabgetasteten k-Räumen PL1b, PL1c, PL2b, PL2c oder durch eine vollständige Abtastung und damit Erfassung eines vollständigen Satzes an entsprechender Messdaten können wie in Figur 6 unten dargestellte vollständig mit erfassen und/oder ergänzten Messdaten gefüllte jeweils separate k-Räume PL1d, PL1e, PL2d und PL2e für die erste und die zweite Phasenlage und beide Ausleserichtungen (also für die verschiedenen Polaritäten der Gradienten in Ausleserichtung, die während dem Erfassen der Messdaten geschaltet wurden) erhalten werden, welche jeweils erste erste Messdaten MD1.1, zweite erste Messdaten MD1.2, zweite zweite Messdaten MD2.1 und erste zweite Messdaten MD2.2 umfassen, aus welchen jeweils, z.B. durch Fouriertransformation, je ein Kombinationsbild KD1.1, KD1.2, KD2.1 und KD2.2 erzeugt werden kann.

Der Vorteil einer Aufnahme von ersten ersten und zweiten ersten Messdaten MD1.1 und MD 1.2 und ersten zweiten und zweiten zweiten Messdaten MD2.2 und MD2.1 wird im Folgenden erläutert.

Der zeitliche Abstand $\Delta TE_{12}$ der beiden aufgenommenen Echosignale E1 und E2 bzw. E1' und E2' bzw. der Auslesefenster A1 und A2 hängt wie gesagt von der gewünschten unterschiedlichen relativen Phasenlage der betrachteten Spinspezies ab. $\Delta TE_{12}$ für zwei feste, gewünschte Phasenlagen nimmt linear mit zunehmender Stärke des Grundmagnetfeldes ab. Bei ca. 3T beträgt $\Delta TE_{12}$ für die beiden Phasenlagen "in-phase" und "opposed-phase" ca. 1,2 Millisekunden.

Wegen der Kürze des zeitlichen Abstands $\Delta TE_{12}$ zwischen den Echossignalen E1 und E2 bzw. E1' und E2' und der damit ebenfalls relativ kurzen Zeit, die für die Aufnahme der Messdaten zur Verfügung steht, wird typischerweise die Auslesebandbreite (engl. "readout bandwidth") vergrößert. Dies führt allerdings dazu, dass das Signal-Rausch-Verhältnis (SNR, engl. "signal-to-noise ratio") verringert wird, weshalb dann oftmals gleiche Messdaten mehrfach aufgenommen werden, um diese mit einem Mittelungsverfahren miteinander verarbeiten zu können, und somit das SNR wieder zu verbessern. Dadurch wird jedoch der oben geschilderte Vorteil der insgesamt kürzeren Messzeit wieder zunichte gemacht.

Derartige Mittelungen (engl. "averages") werden auch in konventionellen Dixon-Verfahren eingesetzt, um das SNR zu verbessern. Eine wie oben beschriebene vergrößerte Auslesebandbreite kann aber durch das dadurch verkleinerte SNR die Anzahl der für eine Mittelung vergleichbarer Qualität erforderlichen Aufnahmen gleicher Messdaten gegenüber den konventionellen Dixon-Verfahren vergrößern.

Durch die Aufnahme der Messdaten der verschiedenen MR-Datensätze mit Auslesegradienten unterschiedlicher Polarität, treten Chemische-Verschiebungs-Artefakte (engl. "chemical shift artifacts") genannte Verschiebungen der Messdaten, die an Grenzflächen zwischen Gebieten auftreten, in welchen jeweils unterschiedliche Spinspezies dominieren, und aus den unterschiedlichen Resonanzfrequenzen der verschiedenen Spinspezies resultieren, in unterschiedlichen Richtungen je nach Polariät des jeweiligen Auslesegradienten auf. Somit sind solche unterschiedlichen aufgenommenen MR-Datensätze, insbesondere bei Fast-Dixon-Verfahren die die Messdaten der unterschiedlichen MR-Datensätze mit Auslesegradienten unterschiedlicher Polarität (bipolare Dixon-Verfahren) auslesen, unterschiedlich von Chemischen-Verschiebungs-Artefakten betroffen. Bei konventionellen Dixon-Verfahren, bei welchen die Messdaten immer mit Auslesegradienten derselben Polarität aufgenommen werden, sind die Messdaten der verschiedenen MR-Datensätze in gleicher Weise verschoben und können leicht zueinander registriert werden. Die unterschiedlichen Richtungen der Chemische-Verschiebungs-Artefakte in den unterschiedlichen aufgenommenen MR-Datensätzen bei bipolaren Dixon-Verfahren können zu deutlichen Abgrenzungs- und/oder Verwischungsartefakten an den Grenzflächen führen, an welchen durch verschiedene betrachteten Spinspezies dominierte Gebiete aneinandergrenzen.

Dies kann z.B. an den idealisierten Signalgleichungen für einen in-phase-Datensatz und einen opposed-phase-Datensatz erklärt werden, wie sie z.B. auch in dem Artikel von Leinhard et al., "Water fat shift displacement artifact correction in two point Dixon imaging", Proc. Intl. Soc. Mag. Reson. Med. 16 (2008), S. 1384, beschrieben sind:

Ein Signal M1($\delta$) am Ort $\delta$ (z.B. am Pixel $\delta$) eines Datensatzes einer ersten Phasenlage, im Folgenden am Beispiel eines in-phase-Datensatzes erläutert, enthält das Signal der ersten Spinspezies, z.B. Wasser, am Ort $\delta$, W($\delta$), plus das Signal der zweiten Spinspezies, z.B. Fett, am Ort $\delta$, der jedoch noch um einen der zwischen den betrachteten Spinspezies vorliegenden chemischen Verschiebung entsprechenden Verschiebungswert chs beaufschlagt werden muss, F($\delta$+chs), wodurch sich ergibt:

$$M1(\delta) = W(\delta) + F(\delta+chs). \qquad (1)$$

Für ein herkömmliches Dixon-Verfahren, bei welchem jeder MR-Datensatz mit Auslesegradienten derselben Polarität aufgenommen wurde ergibt sich für ein Signal M2 eines Datensatzes einer zweiten Phasenlage, im Folgenden am Beispiel eines opposed-phase-Datensatzes erläutert, analog:

$$M2(\delta) = W(\delta) - F(\delta+chs), \qquad (2)$$

wobei die Signale der ersten und der zweiten Spinspezies nun voneinander abgezogen werden müssen, da sie sich bei der Aufnahme in entgegengesetzter Phasenlage befanden.

Für ein Dixon-Verfahren mit unterschiedlicher Polarität der Auslesegradienten für verschiedene MR-Datensätze muss eben wegen der unterschiedlichen Polarität der verwendeten Auslesegradienten der von der chemischen Verschiebung abhängige Verschiebungswert chs in den unterschiedlichen MR-Datensätzen mit unterschiedlichem Vorzeichen beaufschlagt werden. So ergeben sich die Signalgleichungen von in-phase-Datensätzen IP($\delta$) und opposed-phase-Datensätzen OP($\delta$) die mit Auslesegradienten unterschiedlicher Polarität aufgenommen wurden, also z.B. für ein Fast-Dixon-Verfahren, analog zu den obigen Gleichungen (1) und (2) zu:

$$M1(\delta) = W(\delta) + F(\delta + chs), \qquad (3)$$

$$M2(\delta) = W(\delta) - F(\delta - chs). \qquad (4)$$

In herkömmlichen Dixon-Verfahren können, wie sich aus den Gleichungen (1) und (2) ersehen lässt, die Signale der einzelnen Pixel von MR-Bildern der reinen Spinspezies durch Addition bzw. Subtraktion der aufgenommenen MR-Datensätze M1 und M2 erstellt werden:

$$0,5 * (M1(\delta) + M2(\delta)) = W(\delta), \qquad (5)$$

$$0,5 * (M1(\delta) - M2(\delta)) = F(\delta + chs), \qquad (6)$$

wobei z.B. W($\delta$) das Signal eines Wasserbildes am Ort $\delta$ und F($\delta$+chs) das Signal eines Fettbildes am Ort $\delta$+chs bezeichnen kann, wenn Wasser und Fett als verschiedene Spinspezies gewählt wurden.

Wie man sieht, tritt die durch die chemische Verschiebung verursachte Verschiebung der Signale bei dem gewählten Beispiel nur in dem Bild der zweiten Spinspezies F($\delta$+chs) auf. Daher können die beiden erzeugten Bilder F und W der einzelnen Spinspezies z.B. durch eine einfache Registrierung in Übereinstimmung gebracht werden. Analog kann die Verschiebung auch bezüglich der ersten Spinspezies betrachtet werden, im Falle von Wasser und Fett als verschiedenen Spinspezies hat es sich jedoch eingebürgert, die Verschiebung immer relativ zu dem Wassersignal zu bestimmen und daher dem Fettsignal zuzurechnen.

Im Falle einer Aufnahme der verschiedenen MR-Datensätze mit jeweils einer anderen Polarität, sind die Gleichungen (3) und (4) zu verwenden, wodurch sich für eine Addition bzw. eine Subtraktion der verschiedenen MR-Datensätze ergibt:

$$0,5 * (M1(\delta) + M2(\delta)) = 0,5 * (2W(\delta) + F(\delta + chs) - F(\delta - chs)), \quad (7)$$

$$0,5 * (M1(\delta) - M2(\delta)) = 0,5 * (F(\delta + chs) + F(\delta - chs)). \qquad (8)$$

Somit erhält man keine reinen Signale nur einer Spinspezies mehr, denn es bleiben von der chemischen Verschiebung abhängige Störterme übrig. Wie in dem bereits genannten Artikel von Leinhard et al. beschrieben, führen diese zu Abgrenzungsartefakten (engl. "edges") in den erhaltenen MR-Bildern der ersten Spinspezies, insbesondere Wasser, und zu Verwischungsartefakten (engl. "blurring") in den erhaltenen MR-Bildern der zweiten Spinspezies, insbesondere Fett. In dem genannten Artikel von Leinhard et al. wird eine iterative Korrektur vorgeschlagen, um die Störterme auszugleichen, die experimentell bestimmte Regularisierungsfaktoren benötigt.

Durch ein Aufnehmen von ersten ersten und zweiten ersten Messdaten MD1.1 und MD 1.2 und ersten zweiten und zweiten zweiten Messdaten MD2.2 und MD2.1 wie insbesondere mit Bezug auf die Figuren 1 bis 4 erläutert, können nun je Polarität eines zugehörigen Gradienten in Ausleserichtung GR je ein erstes Bild der ersten Phasenlage M1.1, aus dem aufgenommenen Satz erster Messdaten MD1.1 (für die erste Polarität) und ein zweites Bild der ersten Phasenlage M1.2, aus dem aufgenommenen Satz erster Messdaten MD1.2 (für die zweite Polarität), sowie je ein erstes Bild der zweiten Phasenlage M2.1, aus dem aufgenommenen Satz zweiter Messdaten MD2.1 (für die erste Polarität) und ein zweites Bild der zweiten Phasenlage M2.2, aus dem aufgenommenen Satz zweiter Messdaten MD2.2 (für die zweite Polarität) erstellt werden.

Aus diesen können analog zu den Gleichungen (5) und (6) die Signalanteile der einzelnen Spinspezies, wieder am Beispiel von Wasser W und Fett F, am Ort $\delta$ wie folgt, jeweils auf zwei Arten ermittelt werden:

$$0.5*(M1.1(\delta)+M2.1(\delta)) = W(\delta) \qquad (9)$$

$$0.5*(M1.2(\delta)+M2.2(\delta)) = W(\delta) \qquad (10)$$

$$0.5*(M1.1(\delta)-M2.1(\delta)) = F(\delta+chs) \qquad (11)$$

$$0.5*(M1.2(\delta)-M2.2(\delta)) = F(\delta-chs) \qquad (12)$$

Man erhält somit je zwei Sets an Bildern der verschiedenen Spinspezies. W und F, wobei die durch Addition erhaltenen Bilder der ersten Spinspezies (siehe Gleichungen (9) und (10)) frei von Verschiebungsartefakten sind, und die durch Subtraktion erhaltenen Bilder der zweiten Spinspezies (siehe Gleichungen (11 und (12)) je eine globale Verschiebung in unterschiedliche Richtungen ($\pm$ch) aufweisen, die jedoch z.B. durch ein gängiges Registrierungsverfahren oder durch ein gängiges Korrekturverfahren, das eine Korrektur der Verschiebung auf Basis der verwendeten Aufnahmeparameter (insbesondere die Bandbreite und die Feldstärke der verwendeten RF-Pulse und Magnetfelder) leicht ausgeglichen werden kann.

Somit können Störterme in den erhaltenen Bildern der einzelnen betrachteten Spinspezies auf diese Weise vollständig und direkt basierend auf den erfassten Messdaten und mit geringem Rechenaufwand korrigiert werden, und, ohne dass hierzu experimentelle Faktoren bestimmt werden müssten. Darüber hinaus ist durch die direkte Korrektur von Verschiebungsartefakten basierend auf erfassten Messdaten die Bildqualität der erhaltenen Bilder einzelner betrachteter Spinspezies gegenüber Bildern, welche durch iterative Korrekturverfahren erzeugt wurden, erhöht.

Das hierin beschriebene Verfahren einer Erfassung von Messdaten für verschiedene Phasenlagen für jeweils verschiedene Polaritäten der während der Erfassung verwendeten Gradienten in Ausleserichtung kann insbesondere für TSE (Turbo-Spin-Echo) DIXON-Verfahren, aber auch für VIBE (engl. "volumetric interpolated breath-hold examination") DIXON-Verfahren oder für andere bipolare Dixon-Aufnahmeverfahren oder auch für bipolare Feld-Kartographie(field-mapping)-Verfahren, beispielsweise Zerfallsraten(T1/T2/T2*)-Mapping- oder Feldstärken(BO/B1)-Mapping-Verfahren, verwendet werden.

Wie bereits oben insbesondere mit Bezug auf die Figuren 1 und 3 erwähnt, können zu einem auf einen RF-Anregungspuls RF1 oder einen RF-Refokussierungspuls RF2 folgenden, dritten Zeitpunkt dritte Echosignale E3, E3' erzeugt und als weitere Messdaten ausgelesen werden. Diese weiteren Messdaten können z.B. als Navigatordaten ND gespeichert werden.

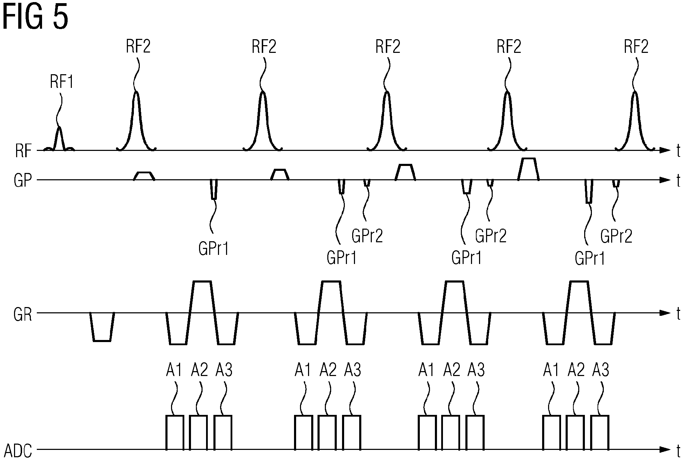

Figur 5 zeigt ein weiteres Beispiel eines schematischen Sequenzdiagramms wie es für ein erfindungsgemäßes Verfahren eingesetzt werden kann. Im Gegensatz zu den in den Figuren 3 und 4 gezeigten Beispielen werden in Figur 5 in dritten Auslesefenstern A3 jeweils nach einem RF-Refokussierungspuls RF2 erzeugte dritte Echosignale ausgelesen. Dazu werden die in Ausleserichtung GR geschalteten Gradienten entsprechend modifiziert, um die Erfassung der weiteren Messdaten zu erlauben. In dem gezeigten Beispiel wird nach jedem RF-Refokussierungspuls RF2 in sich entsprechenden Auslesefenstern A1, A2, A3 jeweils ein Gradient in Ausleserichtung mit einer selben Polarität geschaltet. Es ist jedoch ebenso denkbar, dass die Gradienten in Ausleserichtung (analog zu Figur 4) nach jedem RF-Refokussierungspuls RF2 die Polarität ändern. Das Auslesefenster A3 kann hierbei auch kürzer als die Auslesefenster A1 und/oder A2 gewählt werden, wodurch die räumliche Auflösung der Navigatordaten ND in Ausleserichtung reduziert würde, was aber für die angestrebten Zwecke der Navigatordaten (siehe unten) keinen großen Einfluss haben sollte, dafür aber die Messzeit verkürzen kann.

Die in den Auslesefenstern A3 erfassten weiteren Messdaten können ebenfalls als Navigatordaten ND ausgelesen und gespeichert werden. Beispielsweise, um nur an bestimmten k-Raumpositionen, z.B. an k-Raumzentrumsnahen Positionen, weitere Messdaten als Navigatordaten ND zu erfassen, können in Phasenkodierrichtung GP vor einem dritten Zeitpunkt und damit vor einem dritten Auslesefenster A3, dedizierte Zurückdreh-Phasenkodiergradienten GPr1 geschaltet werden, welche derart wirken, dass zu einem dritten Zeitpunkt ausgelesene weitere Messdaten auf k-Raumtrajektorien liegen, die in einem gewünschten zentrumsnahen Bereich des k-Raums angeordnet sind, insbesondere derart, dass die zu einem dritten Zeitpunkt ausgelesenen weiteren Messdaten auf einer durch das k-Raumzentrum verlaufenden k-Raumtrajektorie liegen. Es können auch nach einem Auslesefenster A3 weitere Zurückdreh-Phasenkodiergradienten GPr2 geschaltet werden, beispielsweise um ein eventuell für das vorangehende Auslesefenster A3 noch nicht vollständig zurückgedrehtes Moment angeregter Spins in Phasenkodierrichtung vor einem folgenden RF-Puls, z.B. einem RF-Refokussierungspuls RF2, möglichst vollständig verschwinden zu lassen.

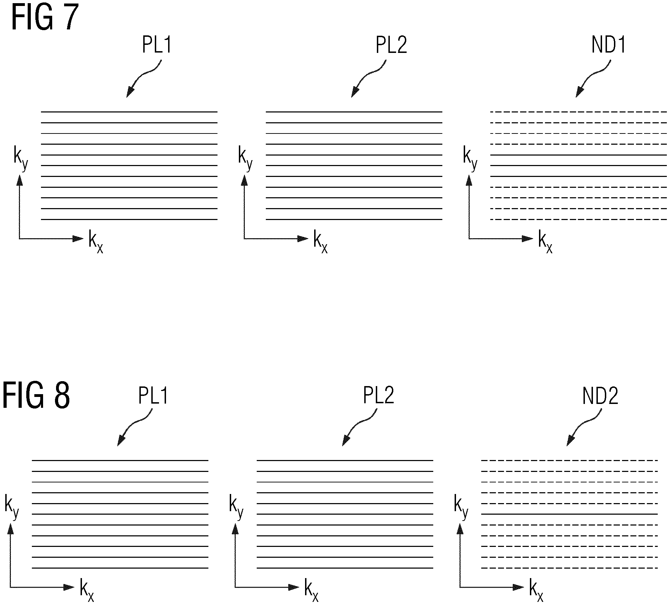

Die Figuren 7 und 8 zeigen weitere Beispiele wie der k-Raum in der von Ausleserichtung kx und Phasenkodierrichtung ky aufgespannten Ebene bei der Aufnahme von Messdaten zu unterschiedlichen Zeitpunkten befüllt werden kann. Beispielhaft werden in den Figuren 7 und 8 je ein vollständig (hier mit k-Raumzeilen) gefüllter k-Raum für einer erste Phasenlage PL1 und für eine zweite Phasenlage PL2 gezeigt. Dabei kann es sich um vollständig mit erfassten Messdaten gefüllte k-Räume PL1 und PL2 handeln oder auch um mit unterabgetastet erfassten Messdaten gefüllte und nachträglich, z.B. mittels ppa, ergänzte k-Räume PL1 und PL2 handeln. Es können auch wie oben beschrieben für jede Ausleserichtung separate k-Räume (hier nicht dargestellt) für jede Phasenlage PL1 und PL2 ermittelt werden. In den Figuren 7 und 8 rechts dargestellt sind darüber hinaus Beispiele für mit Navigatordaten befüllte k-Räume ND1 und ND2.

Der in Figur 7 gezeigte k-Raum ND1 ist im Gegensatz zu den k-Räumen PL1 und PL2 nur in einem zentrumsnahen Bereich des k-Raums, hier in wenigen, die zentrale k-Raumzeile (ky=0) umfassenden und nur wenig von dieser beabstandeten, k-Raumzeilen mit Navigatordaten ND befüllt. Um eine solche Abtastung des k-Raums ND1 zu erreichen, können die mit Bezug auf Figur 5 beschriebenen Zurückdreh-Phasenkodiergradienten GPr1 und GPr2 geschaltet werden. Die Navigatordaten ND können hierbei jeweils mittels einer Anzahl an Auslesefenstern A3 (z.B. also jeweils nach einer entsprechenden Anzahl an RF-Refokussierungspulsen RF2) erfasst werden, welche z.B. der Anzahl der gewünschten k-Raumzeilen entspricht, für welche Navigatordaten ND erfasst werden sollen. Beispielsweise bei einer segmentierten Aufnahme der für die beiden Phasenlagen PL1 und PL2 bestimmten Messdaten, können Navigatordaten ND, die einen k-Raum ND1 füllen, z.B. in jedem erfassten Segment erfasst werden.

Aus derartigen Navigatordaten ND eines k-Raums ND1 kann somit beispielsweise jeweils ein niedrigaufgelöstes Bild des Untersuchungsobjekts durch Fouriertransformation erstellt werden, wodurch man eine Folge an niedrigaufgelösten Bilder des Untersuchungsobjektes, anhand derer eine Bewegung des Untersuchungsobjektes, z.B. unter Anwendung eines Registrierungsverfahrens auf die Folge der niedrigaufgelösten Bilder, erhält, anhand derer auf Basis der Navigatordaten ND Bewegungsdaten als Korrekturdaten KD, die Bewegungen des Untersuchungsobjekts beschreiben, ermittelt werden können (Block 705).

Auf Basis derartiger Bewegungsdaten KD kann eine Bewegungskorrektur von Kombinationsbildern KD1.1, KD2.2, KD1.2, KD2.1 durchgeführt werden, sodass man bewegungskorrigierte Kombinationsbilder KD1.1', KD2.2', KD1.2', KD2.1' erhält (Block 707) .

Beispielsweise auf Basis derartiger ermittelter Bewegungsdaten KD (und/oder auf Basis einer weiter unten beschriebenen bestimmten physiologischen Bewegung als Korrekturdaten KD) kann ein Vergleich mit Daten, die eine erlaubte Bewegung beschreiben, durchgeführt werden, und, wenn der Vergleich ergibt, dass eine durch die ermittelten Bewegungsdaten KD beschriebene Bewegung außerhalb eines Bereichs einer erlaubten Bewegung liegt (Abfrage 709, n), eine erneute Aufnahme von Messdaten 701, welche während der ermittelten Bewegung aufgenommen wurden, veranlasst werden. Ergibt der Vergleich der ermittelten Bewegungsdaten KD mit den Daten, die eine erlaubte Bewegung beschreiben, dass die durch die ermittelten Bewegungsdaten KD beschriebene Bewegung innerhalb des erlaubten Bereichs liegt (Vergleich 709, y) kann mit der Verarbeitung der ggf. bewegungskorrigierten Kombinationsbilder KD1.1, KD2.2, KD1.2, KD2.1 bzw. KD1.1', KD2.2', KD1.2', KD2.1' fortgefahren werden.

Der in Figur 8 rechts dargestellte k-Raum ND2 ist im Gegensatz zu den k-Räumen PL1 und PL2 nur in genau der zentralen k-Raumzeile mit Navigatordaten ND befüllt. Um eine solche Abtastung des k-Raums ND2 zu erreichen, können die mit Bezug auf Figur 5 beschriebenen Zurückdreh-Phasenkodiergradienten GPr1 jeweils derart geschaltet werden, dass bereits vor dem Auslesefenster A3 das Moment der Gradienten in Phasenkodierrichtung verschwindet, weitere Gradienten in Phasenkodierrichtung nach einem Auslesefenster A3 können hier entfallen.

Aus derartigen Navigatordaten ND eines k-Raums ND2 kann (zusätzlich oder alternativ zu den mit Bezug auf die Figur 7 beschriebenen Navigatordaten ND eines k-Raums ND1) beispielsweise eine physiologische Bewegung, z.B. eine Atembewegung, als Korrekturdaten KD bestimmt werden (Block 705). Anhand einer bestimmten physiologischen Bewegung KD kann z.B. ein Gating erfasster Messdaten erfolgen (Block 707), wodurch man bestimmten Zuständen einer bestimmten physiologischen Bewegung zugeordnete Kombinationsbilder KD1.1', KD2.2', KD1.2', KD2.1' erhalten kann.

Beispielsweise auf Basis derartiger ermittelter physiologischer Bewegungsdaten KD kann zusätzlich oder alternativ bestimmt werden, ob für jeden gewünschten Zustand der physiologischen Bewegung bereits ein gewünschtes Kombinationsbild KD1.1', KD2.2', KD1.2', KD2.1' erhalten vorliegt. Ist dies nicht der Fall (Vergleich 709, n), kann eine erneute Aufnahme von Messdaten 701 veranlasst werden. Liegen bereits für alle gewünschten physiologischen Zustände Kombinationsbilder KD1.1', KD2.2', KD1.2', KD2.1' vor (Vergleich 709, y) kann mit der Verarbeitung der ggf. bewegungskorrigierten Kombinationsbilder KD1.1, KD2.2, KD1.2, KD2.1 bzw. KD1.1', KD2.2', KD1.2', KD2.1' fortgefahren werden.

Zusätzlich oder alternativ zu den mit Bezug auf die Figur 7 beschriebenen Navigatordaten ND eines k-Raums ND1 können aus derartigen Navigatordaten ND eines k-Raums ND2 (ebenfalls zusätzlich oder alternativ zu einer oben beschriebenen bestimmten physiologischen Bewegung) beispielsweise eine Phasenkorrekturdaten als Korrekturdaten KD bestimmt werden (Block 705). Eine derartige Bestimmung von Phasenkorrekturdaten aus Navigatordaten ND eines beschriebenen k-Raums ND2 ist grundsätzlich bekannt. Beispielsweise kann wie in der Patentschrift US6160397A beschrieben vorgegangen werden.

Anhand derartiger bestimmter Phasenkorrekturdaten KD kann eine Phasenkorrektur z.B. von zu verschiedenen Echozeiten erfassten Messdaten erfolgen (Block 707), wodurch man phasenkorrigierte Kombinationsbilder KD1.1', KD2.2', KD1.2', KD2.1' erhält (Block 707).

Es ist auch denkbar Navigatordaten ND eines k-Raums ND2, z.B. für eine oben beschriebene Phasenkorrektur, in einem ersten von mehreren Echozügen einer Erfassung erster und zweiter Messdaten zu erfassen, und Navigatordaten ND eines k-Raums ND1, aus welchen niedrigaufgelöste Bilddaten erstellt werden können, in auf den ersten Echozug folgenden Echozügen.

Durch eine derartige Erfassung weiterer Messdaten zu einem dritten Zeitpunkt als Navigatordaten wird eine Gesamtdauer der Messung der ersten und zweiten Messdaten nicht notwendigerweise verlängert, insbesondere wenn auch das Moment der Gradienten in Ausleserichtung z.B. durch Dephasierungsgradienten auf Null reduziert werden soll, bevor erneut ein RF-Puls eingestrahlt wird. Mittels der so erfassten Navigatordaten können zusätzliche Informationen gewonnen werden, und/oder es können Korrekturen der aus den erfassten ersten und zweiten Messdaten erstellten Kombinationsbilder vorgenommen werden.

Anstelle einer bisher beschriebenen kartesischen Abtastung des k-Raums, können Navigatordaten ND auch entlang anderer, z.B. nicht-kartesischer, insbesondere entlang radialer, k-Raumtrajektorien erfasst werden. Dazu wären die während des Erfassens der weiteren Messdaten geschalteten Gradienten entsprechend anzupassen. Beispielsweise könnten aus entlang radialer k-Raumtrajektorien erfasst Navigatordaten besonders einfach eine physiologische Bewegung und gleichzeitig allgemeine Bewegungsdaten des Untersuchungsobjekts bestimmt werden. Weiterhin können zusätzlich oder alternativ bereits bekannt Verfahren zur Verarbeitung von physiologischen Bewegungen, insbesondere einer Atembewegung, wie z.B. PACE(engl. "Prospective Acquisition Correction")-Navigatoren oder Atemanhalte-Techniken angewendet werden, um die Stabilität der Ergebnisse zu erhöhen.

Durch eine derartige Erfassung weitere Messdaten, ohne eine Verlängerung der Messzeit, auf Basis welcher weiterer Messdaten Korrekturdaten ermittelt werden können, kann insbesondere eine intrinsische Bewegungskorrektur (da die Navigatordaten zeitnah mit den ersten und zweiten Messdaten erfasst werden) und/oder eine Phasenkorrektur ohne Zeitverlust durch die Erfassung der weiteren Messdaten durchgeführt werden. Darüber hinaus kann einfach ermittelt werden, ob es sinnvoll ist, erfasste Messdaten erneut zu erfassen, z.B. weil bereits erfasste Messdaten zu stark durch eine Bewegung des Untersuchungsobjektes beeinflusst sind. Somit kann insgesamt die Bildqualität durch die erfassten weiteren Messdaten verbessert werden und/oder weitere diagnostische Daten, insbesondere über eine physiologische Bewegung des Untersuchungsobjektes, aus den erfassten weiteren Messdaten erhalten werden.

Das hierin beschriebene Verfahren einer Erfassung von weiteren Messdaten als Navigatordaten kann insbesondere für TSE DIXON-Verfahren, aber auch für VIBE DIXON-Verfahren oder für andere bipolare Dixon-Aufnahmeverfahren oder auch für bipolare Feld-Kartographie(field-mapping)-Verfahren, beispielsweise Zerfallsraten(T1/T2/T2*)-Mapping- oder Feldstärken(B0/B1)-Mapping-Verfahren, verwendet werden.

Auf Basis mindestens eines ersten und eines zweiten ggf. wie oben beschrieben korrigierten Kombinationsbildes KD1.1' oder KD1.2' und KD2.1' oder KD2.2' oder KD1.1 oder KD1.2 und KD2.1 oder KD2.2, welche z.B. gemäß der Polarität der während des Erfassens der ersten und zweiten Messdaten geschalteten Gradienten in Ausleserichtung derart sortiert wurden (Block 711), dass jeweils ein Kombinationsbild aus ersten Messdaten und ein Kombinationsbild aus zweiten Messdaten mit jeweils gleicher zugehöriger Polarität der Gradienten in Ausleserichtung kann mindestens ein Bild SP1, SP2, SP1.1, SP2.2, SP1.2, SP2.1 erstellt werden, welches nur Signale einer Spinspezies aus der Gruppe der ersten und der zweiten Spinspezies darstellt (Block 713.1 und/oder Block 713.2 und/oder Block 715).

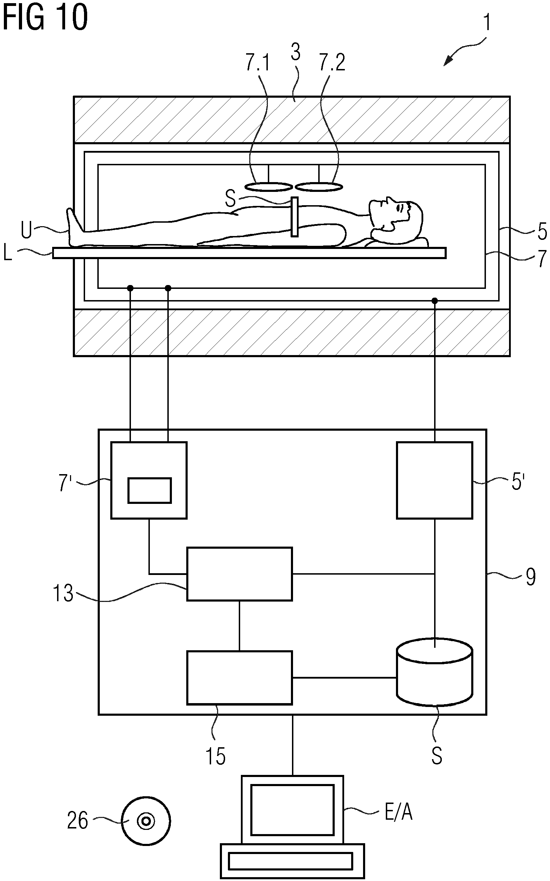

Figur 10 stellt schematisch eine erfindungsgemäße Magnetresonanzanlage 1 dar. Diese umfasst eine Magneteinheit 3 zur Erzeugung des Grundmagnetfeldes, eine Gradienteneinheit 5 zur Erzeugung der Gradientenfelder, eine Hochfrequenzeinheit 7 zur Einstrahlung und zum Empfang von Hochfrequenz-signalen und eine zur Durchführung eines erfindungsgemäßen Verfahrens ausgebildete Steuereinrichtung 9.

In der Figur 10 sind diese Teileinheiten der Magnetresonanzanlage 1 nur grob schematisch dargestellt. Insbesondere kann die Hochfrequenzeinheit 7 aus mehreren Untereinheiten, beispielsweise aus mehreren Spulen wie den schematisch gezeigten Spulen 7.1 und 7.2 oder mehr Spulen bestehen, die entweder nur zum Senden von Hochfrequenzsignalen oder nur zum Empfangen der ausgelösten Hochfrequenzsignale oder für beides ausgestaltet sein können.

Zur Untersuchung eines Untersuchungsobjektes U, beispielsweise eines Patienten oder auch eines Phantoms, kann dieses auf einer Liege L in die Magnetresonanzanlage 1 in deren Messvolumen eingebracht werden. Die Schicht S stellt ein exemplarisches Zielvolumen des Untersuchungsobjekts dar, aus dem Messdaten aufgenommen werden sollen.

Die Steuereinrichtung 9 dient der Steuerung der Magnetresonanzanlage 1 und kann insbesondere die Gradienteneinheit 5 mittels einer Gradientensteuerung 5' und die Hochfrequenzeinheit 7 mittels einer Hochfrequenz-Sende-/Empfangs-Steuerung 7' steuern. Die Hochfrequenzeinheit 7 kann hier-bei mehrere Kanäle umfassen, auf denen Signale gesendet oder empfangen werden können.

Die Hochfrequenzeinheit 7 ist zusammen mit ihrer Hochfrequenz-Sende-/Empfangs-Steuerung 7' für die Erzeugung und das Einstrahlen (Senden) eines Hochfrequenz-Wechselfeldes zur Manipulation der Spins in einem zu manipulierenden Be-reich (beispielsweise in zu messenden Schichten S) des Untersuchungsobjekts U zuständig. Dabei wird die Mittenfrequenz des, auch als B1-Feld bezeichneten, Hochfrequenz-Wechselfeldes in aller Regel möglichst so eingestellt, dass sie nahe der Resonanzfrequenz der zu manipulierenden Spins liegt. Abweichungen von der Mittenfrequenz von der Resonanzfrequenz werden als Off-Resonanz bezeichnet. Zur Erzeugung des B1-Feldes werden in der Hochfrequenzeinheit 7 mittels der Hochfrequenz-Sende-/Empfangs-Steuerung 7' gesteuerte Ströme an den HF-Spulen angelegt.

Weiterhin umfasst die Steuereinrichtung 9 eine Messdatenverarbeitungseinheit 15, mit welcher erfindungsgemäße Messdatensätze aus erfindungsgemäß aufgenommenen Messdaten erstellt und erfindungsgemäß verarbeitet werden können. Die Steuereinrichtung 9 ist insgesamt dazu ausgebildet, ein erfindungsgemäßes Verfahren durchzuführen.

Eine von der Steuereinrichtung 9 umfasste Recheneinheit 13 ist dazu ausgebildet alle für die nötigen Messungen und Bestimmungen nötigen Rechenoperationen auszuführen. Hierzu benötigte oder hierbei ermittelte Zwischenergebnisse und Ergebnisse können in einer Speichereinheit S der Steuereinrichtung 9 gespeichert werden. Die dargestellten Einheiten sind hierbei nicht unbedingt als physikalisch getrennte Einheiten zu verstehen, sondern stellen lediglich eine Untergliederung in Sinneinheiten dar, die aber auch z.B. in weniger oder auch in nur einer einzigen physikalischen Einheit realisiert sein können.

Über eine Ein-/Ausgabeeinrichtung E/A der Magnetresonanzanlage 1 können, z.B. durch einen Nutzer, Steuerbefehle an die Magnetresonanzanlage geleitet werden und/oder Ergebnisse der Steuereinrichtung 9 wie z.B. Bilddaten angezeigt werden.

Ein hierin beschriebenes Verfahren kann auch in Form eines Computerprogrammprodukts vorliegen, welches ein Programm umfasst und das beschriebene Verfahren auf einer Steuereinrichtung 9 implementiert, wenn es auf der Steuereinrichtung 9 ausgeführt wird. Ebenso kann ein elektronisch lesbarer Datenträger 26 mit darauf gespeicherten elektronisch lesbaren Steuerinformationen vorliegen, welche zumindest ein solches eben beschriebenes Computerprogramm-produkt umfassen und derart ausgestaltet sind, dass sie bei Verwendung des Datenträgers 26 in einer Steuereinrichtung 9 einer Magnetresonanzanlage 1 das beschriebene Verfahren durchführen.

**Patentansprüche**

1. Verfahren zur Aufnahme von mindestens zwei Messdatensätzen eines Untersuchungsobjektes mittels Magnetresonanz umfassend die Schritte:

   - Einstrahlen mindestens eines RF-Anregungspulses (RF1) zur Anregung von Spins in dem Untersuchungsobjekt (U),
   - Erfassen erster Messdaten (MD1.1; MD1.2) eines nach einem eingestrahlten RF-Anregungspuls (RF1) erzeugten Echosignals zu einem ersten Zeitpunkt, zu dem Spins einer ersten in dem Untersuchungsobjekt (U) vorhandenen Spinspezies zu Spins einer zweiten in dem Untersuchungsobjekt (U) vorhandenen Spinspezies eine erste Phasenlage (PL1) aufweisen, unter Schalten eines Auslesegradienten (GR) einer ersten Polarität,
   - Erfassen zweiter Messdaten (MD2.2; MD2.1) eines durch den RF-Anregungspuls (RF1) erzeugten Echosignals zu einem zweiten Zeitpunkt, zu dem Spins der ersten in dem Untersuchungsobjekt (U) vorhandenen Spinspezies zu Spins der zweiten in dem Untersuchungsobjekt (U) vorhandenen Spinspezies eine zweite, von der ersten Phasenlage (PL1) verschiedenen, Phasenlage (PL2) aufweisen, unter Schalten eines Auslesegradienten (GR) einer zweiten Polarität, wobei die erste und die zweite Polarität verschieden sind,
   - Erzeugen eines ersten Kombinationsbildes (KD1.1, KD1.1'; KD1.2, KD1.2') auf Basis der erfassten ersten Messdaten (MD1.1; MD1.2),
   - Erzeugen eines zweiten Kombinationsbildes (KD2.2, KD2.2'; KD2.1, KD2.1') auf Basis der erfassten zweiten Messdaten (MD2.2; MD2.1),
   - Erstellen mindestens eines Bildes (SP1.1, SP1.2, SP1; SP2.2, SP2.1, SP2), welches nur Signale einer Spinspezies aus der Gruppe der ersten und der zweiten Spinspezies darstellt, auf Basis des ersten und des zweiten Kombinationsbildes(KD1.1, KD1.1'; KD1.2, KD1.2'; KD2.2, KD2.2'; KD2.1, KD2.1').

2. Verfahren nach Anspruch 1, wobei Messdaten eines Messdatensatzes der zwei Messdatensätze (MD1.1, MD1.2; MD2.1, MD2.2) zu einem Zeitpunkt erfasst werden, zu dem Spins der ersten in dem Untersuchungsobjekt (U) vorhandenen Spinspezies und Spins der zweiten in dem Untersuchungsobjekt (U) vorhandenen Spinspezies eine selbe Phase aufweisen, und/oder wobei Messdaten eines Messdatensatzes der zwei Messdatensätze zu einem Zeitpunkt erfasst werden, zu dem Spins der ersten in dem Untersuchungsobjekt (U) vorhandenen Spinspezies eine Phase aufweisen, die der Phase, die Spins der zweiten in dem Untersuchungsobjekt (U) vorhandenen Spinspezies aufweisen, entgegengesetzt ist.

**3.** Verfahren nach einem der vorhergehenden Ansprüche, wobei nach einem eingestrahlten RF-Anregungspuls (RF1) mindestens ein RF-Refokussierungspuls (RF2) eingestrahlt wird, und ein erster und ein zweiter Zeitpunkt jeweils zeitlich auf einen Zeitpunkt folgen, zu dem ein RF-Refokussierungspuls (RF1; RF2) eingestrahlt wurde.

**4.** Verfahren nach einem der vorhergehenden Ansprüche, wobei unter Schalten eines Auslesegradienten (GR) der zweiten Polarität zweite erste Messdaten (MD1.2; MD1.1) eines durch den RF-Anregungspuls (RF1) erzeugten Echosignals zu einem Zeitpunkt erfasst werden, in dem Spins der ersten in dem Untersuchungsobjekt (U) vorhandenen Spinspezies zu Spins der zweiten in dem Untersuchungsobjekt (U) vorhandenen Spinspezies die erste Phasenlage aufweisen, und wobei unter Schalten eines Auslesegradienten (GR) der ersten Polarität zweite zweite Messdaten (MD2.1; MD2.2) eines durch den RF-Anregungspuls (RF1) erzeugten Echosignals zu einem Zeitpunkt erfasst werden, in dem Spins der ersten in dem Untersuchungsobjekt (U) vorhandenen Spinspezies zu Spins der zweiten in dem Untersuchungsobjekt (U) vorhandenen Spinspezies die zweite Phasenlage aufweisen.

**5.** Verfahren nach einem der vorhergehenden Ansprüche, wobei erste erste und erste zweite Messdaten (MD1.1, MD2.2; MD1.2, MD2.1) nach einem gemeinsamen RF-Anregungspuls (RF1) erfasst werden, und zweite erste und zweite zweite Messdaten (MD1.2, MD2.1; MD1.1, MD2.2) nach einem anderen RF-Anregungspuls (RF1') erfasst werden, oder erste erste, erste zweite, zweite erste und zweite zweite Messdaten (MD1.1, MD1.2, MD2.1, MD2.2) nach einem gemeinsamen RF-Anregungspuls (RF1) erfasst werden.

**6.** Verfahren nach Anspruch 5, wobei erste erste und erste zweite Messdaten (MD1.1, MD2.2; MD1.2, MD2.1) nach einem gemeinsamen RF-Anregungspuls (RF1) erfasst werden, und zweite erste und zweite zweite Messdaten (MD1.2, MD2.1; MD1.1, MD2.2) nach einem anderen RF-Anregungspuls (RF1') erfasst werden, und wobei ein Erfassen erster erster und erster zweiter Messdaten (MD1.1, MD2.2; MD1.2, MD2.1) einerseits und ein Erfassen ihrer bezüglich ihrer k-Raumposition entsprechenden zweiter ersten und zweiter zweiten Messdaten (MD1.2, MD2.1; MD1.1, MD2.2) andererseits mit einem möglichst kleinen zeitlichen Abstand erfolgt.

**7.** Verfahren nach einem der Ansprüche 4 bis 6, wobei nach einem eingestrahlten RF-Anregungspuls (RF1) eine Folge von RF-Refokussierungspulsen (RF2) eingestrahlt wird, und nach aufeinanderfolgenden RF-Refokussierungspulsen (RF2) der Folge abwechselnd erste erste und erste zweite Messdaten (MD1.1, MD2.2; MD1.2, MD2.1) einerseits und zweite erste und zweite zweite Messdaten (MD1.2, MD2.1; MD1.1, MD2.2)andererseits erfasst werden.

**8.** Verfahren nach einem der Ansprüche 4 bis 7, wobei erfasste Messdaten (MD1.1, MD1.2, MD2.1, MD2.2) einen gemäß Nyquist unterabgetasteten Satz an Messdaten ergeben, in welchem z.B. nur Messdaten jeder zweiten k-Raumzeile erfasst sind, und wobei die Messdaten mithilfe von mehreren Empfangsspulen erfasst werden und unterabgetastete Sätze von erfassten Messdaten unter Verwendung einer parallelen Bildgebungstechnik zu vollständigen Sätzen an Messdaten ergänzt werden.

**9.** Verfahren nach einem der vorhergehenden Ansprüche, wobei zu einem dritten Zeitpunkt nach einem RF-Anregungs- oder RF-Refokussierungspuls (RF1 oder RF2) weitere Messdaten ausgelesen und als Navigatordaten (ND) gespeichert werden.

**10.** Verfahren nach Anspruch 9, wobei auf Basis der Navigatordaten (ND) Phasenkorrekturdaten (KD) zur Korrektur einer Phase zu verschiedener Echozeiten erfasster Messdaten ermittelt werden.

**11.** Verfahren nach einem der Ansprüche 9 oder 10, wobei auf Basis der Navigatordaten (ND) Bewegungsdaten (KD), die Bewegungen des Untersuchungsobjekts beschreiben, ermittelt werden.

**12.** Verfahren nach Anspruch 11, wobei auf Basis der ermittelten Bewegungsdaten (KD) eine Bewegungskorrektur von Kombinationsbildern (KD1.1, KD1.2, KD2.1, KD2.2) durchgeführt wird und/oder ein Zustand einer physiologischen Bewegung bestimmt wird und/oder auf Basis der ermittelten Bewegungsdaten oder des bestimmten physiologischen Zustands ein Vergleich mit Daten, die eine erlaubte Bewegung beschreiben, durchgeführt wird, und, wenn der Vergleich ergibt, dass eine durch die ermittelten Bewegungsdaten oder durch den bestimmten physiologischen Zustand beschriebene Bewegung außerhalb eines Bereichs einer erlaubten Bewegung liegt, eine erneute Aufnahme von Messdaten, welche während der ermittelten Bewegung aufgenommen wurden, veranlasst wird.

**13.** Magnetresonanzanlage (1) umfassend, eine Magneteinheit (3), eine Gradienteneinheit (5), eine Hochfrequenzeinheit (7) und eine Steuereinrichtung (9) mit einer Hochfrequenz-Sende-/Empfangs-Steuerung (7') und einer Messdatenverarbeitungseinheit (15), wobei die Steuereinrichtung (9) dazu ausgebildet ist, ein Verfahren nach einem der Ansprüche 1 bis 12 auf der Magnetresonanzanlage (1) auszuführen.

14. Computerprogramm, welches direkt in einen Speicher einer Steuereinrichtung (9) einer Magnetresonanzanlage (1) ladbar ist, mit Programm-Mitteln, um die Schritte des Verfahrens nach einem der Ansprüche 1 bis 12 auszuführen, wenn das Programm in der Steuereinrichtung (9) der Magnetresonanzanlage (1) ausgeführt wird.

15. Elektronisch lesbarer Datenträger mit darauf gespeicherten elektronisch lesbaren Steuerinformationen, welche zumindest ein Computerprogramm nach Anspruch 14 umfassen und derart ausgestaltet sind, dass sie bei Verwendung des Datenträgers in einer Steuereinrichtung (9) einer Magnetresonanzanlage (1) ein Verfahren nach einem der Ansprüche 1 bis 12 durchführen.

FIG 1

FIG 2

**FIG 3**

**FIG 4**

# FIG 5

FIG 6

PL1a

PL2a

PL1b

PL2b

PL1c

PL2c

PL1d

PL2d

PL1e

PL2e

$k_x$ $k_y$

FIG 7

PL1

PL2

ND1

$k_y$ $k_x$

$k_y$ $k_x$

$k_y$ $k_x$

FIG 8

PL1

PL2

ND2

$k_y$ $k_x$

$k_y$ $k_x$

$k_y$ $k_x$

# FIG 9

# FIG 10

Europäisches
Patentamt

European
Patent Office

Office européen
des brevets

# EUROPÄISCHER RECHERCHENBERICHT

Nummer der Anmeldung

EP 19 19 8062

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2017 207128 A1 (SIEMENS HEALTHCARE GMBH [DE]) 31. Oktober 2018 (2018-10-31) <br> * Abbildungen 1,2,3,4,5 * <br> * Absatz [0046] - Absatz [0083] * <br> ----- | 1-3,9-15 | INV. <br> G01R33/48 <br> G01R33/561 |
| X | US 2019/257906 A1 (ZELLER MARIO [DE]) 22. August 2019 (2019-08-22) <br> * Abbildungen 1,2,6,10,14 * <br> * Absatz [0077] - Absatz [0080] * <br> * Absatz [0086] - Absatz [0088] * <br> * Absatz [0106] - Absatz [0131] * <br> * Absatz [0136] - Absatz [00137] * <br> * Absatz [0143] - Absatz [0146] * <br> * Absatz [0150] * <br> ----- | 1-3,9-15 | |
| X,D | JINGFEI MA ET AL: "Fast spin-echo triple-echo Dixon (fTED) technique for efficient T2-weighted water and fat imaging", MAGNETIC RESONANCE IN MEDICINE, JOHN WILEY & SONS, INC, US, Bd. 58, Nr. 1, 20. Juli 2007 (2007-07-20), Seiten 103-109, XP007909490, ISSN: 0740-3194, DOI: 10.1002/MRM.21268 [gefunden am 2007-07-20] <br> * Abbildung 1 * <br> * Kurzzusammenfassung * <br> * Abschnitt "MATERIALS AND METHODS" * <br> * Abschnitt "EXPERIMENTS AND RESULTS" * <br> ----- <br> -/-- | 1-3, 13-15 | |

**RECHERCHIERTE SACHGEBIETE (IPC)**

G01R

Der vorliegende Recherchenbericht wurde für alle Patentansprüche erstellt

| Recherchenort | Abschlußdatum der Recherche | Prüfer |
|---|---|---|
| München | 20. März 2020 | Durst, Markus |

EPO FORM 1503 03.82 (P04C03)

Seite 1 von 2

Europäisches Patentamt
European Patent Office
Office européen des brevets

# EUROPÄISCHER RECHERCHENBERICHT

**Nummer der Anmeldung**

EP 19 19 8062

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | LI ZHIQIANG ET AL: "Rapid water and lipid imaging with T2 mapping using a radial IDEAL-GRASE technique", MAGNETIC RESONANCE IN MEDICINE, JOHN WILEY & SONS, INC, UNITED STATES, Bd. 61, Nr. 6, 7. April 2009 (2009-04-07), Seiten 1415-1424, XP007913768, ISSN: 1522-2594, DOI: 10.1002/MRM.21918 [gefunden am 2009-04-07] * Abbildung 1 * * Kurzzusammenfassung * * Seite 1416 - Seite 1418 * ----- | 1-8, 13-15 | |
| X | HUANZHOU YU ET AL: "Phase and amplitude correction for multi-echo water-fat separation with bipolar acquisitions", JOURNAL OF MAGNETIC RESONANCE IMAGING, Bd. 31, Nr. 5, 23. April 2010 (2010-04-23), Seiten 1264-1271, XP055099890, ISSN: 1053-1807, DOI: 10.1002/jmri.22111 * Abbildung 1 * * Seite 1264 - Seite 1266 * ----- | 1,2,4-6, 8,13-15 | |
| A | REEDER S B ET AL: "Multicoil Dixon Chemical Species Separation With an Iterative Least-Squares Estimation Method", MAGNETIC RESONANCE IN MEDICINE, JOHN WILEY & SONS, INC, US, Bd. 51, Nr. 1, 29. Dezember 2003 (2003-12-29), Seiten 35-45, XP002378908, ISSN: 0740-3194, DOI: 10.1002/MRM.10675 * Abschnitt "THEORY" * ----- | 1-15 | |

**RECHERCHIERTE SACHGEBIETE (IPC)**

Der vorliegende Recherchenbericht wurde für alle Patentansprüche erstellt

| Recherchenort | Abschlußdatum der Recherche | Prüfer |
|---|---|---|
| München | 20. März 2020 | Durst, Markus |

EPO FORM 1503 03.82 (P04C03)

Seite 2 von 2

**ANHANG ZUM EUROPÄISCHEN RECHERCHENBERICHT
ÜBER DIE EUROPÄISCHE PATENTANMELDUNG NR.**

EP 19 19 8062

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

20-03-2020

| Im Recherchenbericht angeführtes Patentdokument | Datum der Veröffentlichung | Mitglied(er) der Patentfamilie | Datum der Veröffentlichung |
|---|---|---|---|
| DE 102017207128 A1 | 31-10-2018 | DE 102017207128 A1<br>US 2018313927 A1 | 31-10-2018<br>01-11-2018 |
| US 2019257906 A1 | 22-08-2019 | EP 3528002 A1<br>US 2019257906 A1 | 21-08-2019<br>22-08-2019 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6160397 A

**In der Beschreibung aufgeführte Nicht-Patentliteratur**

- **MA et al.** Fast Spin-Echo Triple-Echo Dixon (fTED) Technique for Efficient T2-Weighted Water and Fat Imaging. *MRM,* 2007, vol. 58, 103-109

- **LEINHARD et al.** Water fat shift displacement artifact correction in two point Dixon imaging. *Proc. Intl. Soc. Mag. Reson. Med.,* 2008, vol. 16, 1384